(19) Europäisches Patentamt
European Patent Office
Office européen des brevets

(11) **EP 4 734 147 A1**

(12) **EUROPEAN PATENT APPLICATION**

(43) Date of publication:
**29.04.2026 Bulletin 2026/18**

(21) Application number: **24208689.0**

(22) Date of filing: **24.10.2024**

(51) International Patent Classification (IPC):
***H01J 37/147*** (2006.01)     ***H01J 37/28*** (2006.01)

(52) Cooperative Patent Classification (CPC):
**H01J 37/1477; H01J 37/28;** H01J 2237/0453;
H01J 2237/1205; H01J 2237/121; H01J 2237/153

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• WANG, Shih-Chi
  **5500 AH Veldhoven (NL)**
• KRECINIC, Faruk
  **5500 AH Veldhoven (NL)**
• MANGNUS, Albertus, Victor, Gerardus
  **5500 AH Veldhoven (NL)**

(74) Representative: **ASML Netherlands B.V.
Corporate Intellectual Property
P.O. Box 324
5500 AH Veldhoven (NL)**

(54) **CHARGED PARTICLE-OPTICAL ARRANGEMENT FOR A CHARGED PARTICLE BEAM APPARATUS**

(57) The present disclosure relates to a charged particle-optical element for a charged particle beam apparatus, wherein the charged particle-optical element is configured to operate on a plurality of beamlets of charged particles, and the charged particle-optical element comprises: a first electrode, wherein a plurality of first apertures for passage of the plurality of beamlets are defined in a beam area of the first electrode; and a second electrode, wherein a plurality of second apertures for passage of the plurality of beamlets are defined in a beam area of the second electrode, wherein the first electrode is configured to adopt a target curved profile upon application of a potential difference between the first electrode and the second electrode.

## Fig. 7

**Description**

<u>FIELD</u>

The embodiments provided herein generally relate to apparatus for directing charged particles such as electrons towards a sample and related apparatus and methods.

<u>BACKGROUND</u>

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems with a charged particle beam have been used to assess objects, such as a pattern inspection system used, for example, to detect pattern defects. These tools typically use electron microscopy techniques, such as a scanning electron microscope (SEM). In an embodiment of SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incident charged particles. As an area of the sample is inspected, the signals comprise data which is processed to generate the inspection image corresponding to the inspected area of the sample.

Some pattern assessment systems may be configured to operate on a plurality of beams of electrons to form a plurality of probing spots on the target. The plurality of beams may be arranged in a beam grid. A pattern assessment system may comprise a plurality of electron-optical arrangements configured to operate on the plurality of beams. For example, the pattern assessment system may comprise a collimator arrangement, which is configured to operate on the plurality of beams such that each one of the plurality of beams propagates in substantially the same direction.

Known collimator arrangements suffer from various disadvantages. For instance, some known collimator arrangements may be sensitive to mechanical vibrations. Other known collimator arrangements may be less sensitive to mechanical vibrations, but may require the plurality of beams to be arranged in an asymmetric beam grid, which increases complexity.

<u>SUMMARY</u>

It is an object of the present disclosure to provide an improved charged particle-optical element for a pattern assessment system, e.g. an improved collimator arrangement for an electron microscope. One specific object of the present disclosure is to provide a collimator arrangement which is insensitive to mechanical vibrations and which allows the plurality of beams to be arranged in a symmetric beam grid.

According to an aspect of the invention, there is provided a charged particle-optical element for a charged particle beam apparatus. The charged particle-optical element is configured to operate on a plurality of beamlets of charged particles. The charged particle-optical element comprises a first electrode, wherein a plurality of first apertures for passage of the plurality of beamlets are defined in a beam area of the first electrode. The charged particle-optical element comprises a second electrode, wherein a plurality of second apertures for passage of the plurality of beamlets are defined in a beam area of the second electrode. The first electrode is configured to adopt a target curved profile upon application of a potential difference between the first electrode and the second electrode.

According to an aspect of the invention, there is provided a method of operating a charged particle-optical element of a charged particle beam apparatus for directing a plurality of beamlets of charged particles towards a sample. The charged particle-optical element comprises a first electrode, wherein a plurality of first apertures for passage of the plurality of beamlets are defined in a beam area of the first electrode. The charged particle-optical element comprises a second electrode, wherein a plurality of second apertures for passage of the plurality of beamlets are defined in a beam area of the second electrode. The method comprises applying a potential difference between the first electrode and the second electrode. The application of the potential difference between the first electrode and the second electrode reduces a difference between the curvature of the beam area of the first electrode and a target curvature for the beam area of the first electrode..

Advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary assessment apparatus.

FIG. 2 is a schematic diagram illustrating an exemplary multibeam charged particle-optical device that is part of the exemplary assessment apparatus of FIG. 1.

FIG. 3 is a schematic diagram of an exemplary charged particle-optical device comprising a collimator element array and a scan-deflector array that is part of the exemplary assessment apparatus of FIG. 1.

FIG. 4 is a schematic diagram of an exemplary charged particle-optical device array comprising the charged particle-optical devices of FIG. 3.

FIG. 5 is a schematic diagram of an alternative exemplary charged particle-optical device that is part of the exemplary assessment apparatus of FIG. 1.

FIG. 6 schematically depicts a known collimator element array.

FIG. 7 schematically depicts a collimator element array in accordance with an embodiment.

FIG. 8 schematically depicts a three-dimensional view of beam areas of electrodes of the collimator element array depicted in FIG. 7.

FIG. 9 schematically depicts an electrode of the collimator element array depicted in FIG. 7.

FIG. 10 schematically depicts the paths of two primary beams of charged particles passing through the collimator element array depicted in FIG. 7.

FIG. 11 depicts a plurality of electrodes which may be used to form the collimator element array of FIG. 7.

FIG. 12 depicts an upbeam electrode comprising a plurality of features configured to adapt the stiffness of the electrode.

FIG. 13 depicts a collimator element array in accordance with another embodiment.

FIG. 14 depicts a collimator element array in accordance with another embodiment.

FIG. 15 depicts a collimator element array in accordance with another embodiment.

FIG. 16 depicts a collimator element array in accordance with another embodiment.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. The single beam may be referred to as a primary beam. For higher throughput such as for assessment, some designs of apparatus use multiple focused beams of charged particles (e.g. electrons), i.e. a multibeam of primary beams of charged particles. The multibeam of primary beams may be arranged in a beam grid. The component beams of the multibeam may be referred to as primary beams, beams, sub-beams or beamlets. The primary beams in the beam grid (or a multibeam) may scan different parts of a target simultaneously. Beams in a beam grid may have a determined relative position to each other within the beam grid. The position of the beams within the beam grid may correspond to a pattern such as a regular pattern such as two-dimensional grid of a repeating pattern having a tessellating shape, such as a rectangular grid (e.g. a square grid) or a hexagonal grid. Note reference to a beam grid herein is intended also to refer to a multibeam in which the beams may be arranged in a non-regular pattern. A multibeam assessment apparatus may therefore assess a target much quicker, e.g. by moving the target at a higher speed, than a single-beam assessment apparatus.

An implementation of a known multibeam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

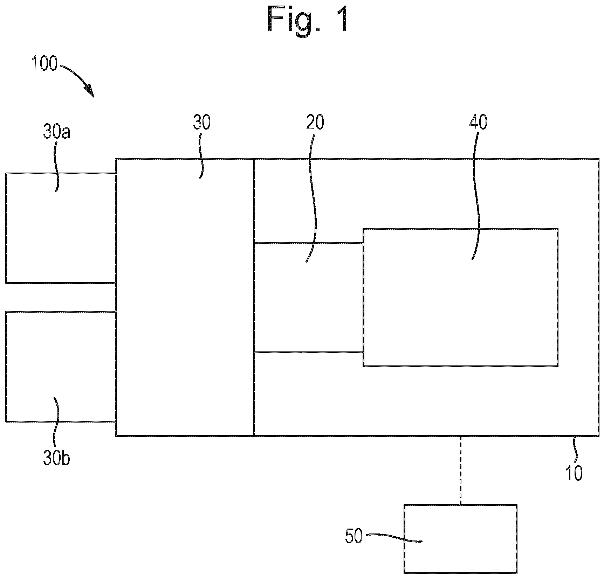

Reference is now made to **FIG. 1,** which is a schematic diagram illustrating an exemplary assessment apparatus 100, or inspection apparatus. The assessment apparatus 100 of **FIG. 1** includes a vacuum chamber 10, a load lock chamber 20, a charged particle-optical apparatus, an equipment front end module (EFEM) 30 and a controller 50. The charged particle-optical apparatus may be within the vacuum chamber 10. The charged particle-optical apparatus may comprise a charged particle-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. A charged particle-optical apparatus may comprise either a single beam or a multibeam charged particle-optical device.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of a main chamber 10 housing an electron beam assessment apparatus, it should be noted that aspects of the disclosure in their broadest sense are not limited to a chamber housing a charged particle-optical device 40. Rather, it is appreciated that the foregoing principles may also be applied to other apparatuses and other arrangements of apparatus that operate under the second pressure.

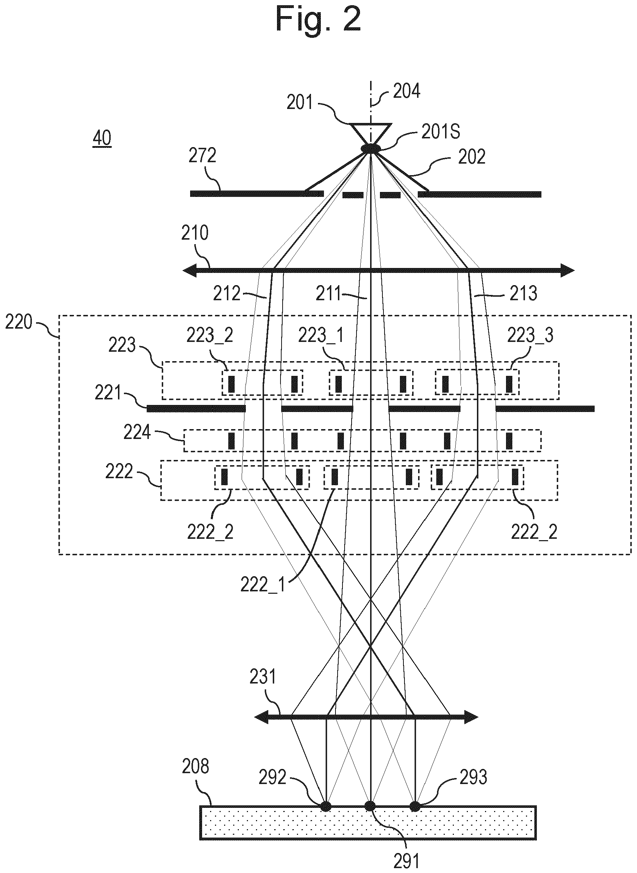

Reference is now made to **FIG. 2,** which is a schematic diagram of an exemplary multibeam charged particle-optical device 40 and a stage of an assessment apparatus, e.g. the assessment apparatus 100 of **FIG. 1.** The exemplary multibeam charged particle-optical device 40 depicted in **FIG. 2** is an example of the charged particle-optical device 40 of the assessment apparatus 100 of **FIG. 1.** In an alternative embodiment, the assessment apparatus 100 is a single-beam assessment apparatus. The charged particle-optical device 40 may comprise an electron source 201, a beam former array 272 (also known as a gun aperture plate, a coulomb aperture array or a pre-sub-beamforming aperture array), a condenser lens 210, a source converter (or micro-optical array) 220, an objective lens 231, and a target 208 (for example a sample). In an embodiment the condenser lens 210 is magnetic. The target 208 may be supported by a support on the stage. The stage may be motorized. The stage moves the target 208 relative to the charged particle-optical device 40. The electron source 201, the beam former array 272, the condenser lens 210 may be the components of an illumination apparatus comprised by the charged particle-optical device 40. The source converter 220 (also known as a source conversion unit), described in more detail below, and the objective lens 231 may be the components of a projection apparatus comprised by the charged particle-optical device 40.

The electron source 201, the beam former array 272, the condenser lens 210, the source converter 220, and the objective lens 231 may be described as being aligned with a primary electron-optical axis 204 of the charged particle-optical device 40. The electron source 201 may generate a primary beam 202 generally along the electron-optical axis 204 and with a source crossover (virtual or real) 201s. During operation, the electron source 201 is configured to emit electrons. The electrons are extracted or accelerated by an extractor and/or an anode to form the primary beam 202. In the present disclosure, the "upbeam" direction may be a direction parallel to the electron-optical axis 204 and towards the electron source 201, and the "downbeam" direction may be a direction parallel to the electron-optical axis 204 and towards the target 208 (or away from the source 201). The "beamwise" direction may refer generally to a direction that is parallel to the electron-optical axis 204 (i.e. the upbeam direction and/or the downbeam direction). Additionally or alternatively, the "downbeam" direction may be the direction in which the beam grid propagates at a given point within the charged particle-optical device 40, and the "upbeam" direction may be a direction which is opposite to the downbeam direction.

The beam former array 272 cuts the peripheral electrons of primary electron beam 202 to reduce a consequential Coulomb effect. The primary-electron beam 202 may be trimmed into a specified number of sub-beams, such as three sub-beams 211, 212 and 213, by the beam former array 272. It should be understood that the description is intended to apply to a charged particle-optical device 40 with any number of sub-beams such as one, two or more than three for example twenty five, one hundred, or even around three hundred. The beam former array 272, in operation, is configured to block off peripheral electrons to reduce the Coulomb effect.

The source converter 220 is configured to convert the beam (including sub-beams if present) transmitted by the beam former array 272 into the sub-beams that are projected towards the target 208. In an embodiment the source converter is a unit. Alternatively, the term source converter may be used simply as a collective term for the group of components that form the beamlets from the sub-beams.

As shown in **FIG. 2,** in an embodiment the charged particle-optical device 40 comprises a beam-limiting aperture array 221 with an aperture pattern (i.e. apertures arranged in a formation) configured to define the outer dimensions of the beamlets (or sub-beams) projected towards the target 208. In an embodiment the beam-limiting aperture array 221 is part of the source converter 220. In an alternative embodiment the beam-limiting aperture array 221 is part of the system upbeam of the main device. In an embodiment, the beam-limiting aperture array 221 divides one or more of the sub-beams 211, 210, 213 into beamlets such that the number of beamlets projected towards the target 208 is greater than the number of sub-beams transmitted through the beam former array 272. In an alternative embodiment, the beam-limiting aperture array 221 keeps the number of the sub-beams incident on the beam-limiting aperture array 221, in which case the number of sub-beams may equal the number of beamlets projected towards the target 208.

As shown in **FIG. 2,** in an embodiment the charged particle-optical device 40 comprises a pre-bending deflector array 223 with pre-bending deflectors 223_1, 223_2, and 223_3 to bend the sub-beams 211, 212, and 213 respectively. The pre-bending deflectors 223_1, 223_2, and 223_3 may bend the path of the sub-beams 211, 210, and 213 onto the beam-limiting aperture array 221.

The charged particle-optical device 40 may also include an image-forming element array 222 with image-forming deflectors 222_1, 222_2, and 222_3. There is a respective deflector 222_1, 222_2, and 222_3 associated with the path of each beamlet. The deflectors 222_1, 222_2, and 222_3 are configured to deflect the paths of the beamlets towards the electron-optical axis 204. The deflected beamlets form virtual images (not shown) of source crossover 201s. In the current embodiment, these virtual images are projected onto the target 208 by the objective lens 231 and form probe spots 291, 292, 293 thereon. The charged particle-optical device 40 may also include an aberration compensator array 224 configured to compensate aberrations that may be present in each of the sub-beams. In an embodiment the aberration compensator array 224 comprises a lens configured to operate on a respective beamlet. The lens may take the form or an array of lenses. The lenses in the array may operate on a different beamlet of the multibeam. The aberration compensator array 224 may, for example, include a field curvature compensator array (not shown) for example with micro-lenses. The field curvature compensator and micro-lenses may, for example, be configured to compensate the individual sub-beams for field curvature aberrations evident in the probe spots, 291, 292, and 293. The aberration compensator array 224 may include an astigmatism compensator array (not shown) with micro-stigmators. The micro-stigmators may, for example, be controlled to operate on the sub-beams to compensate astigmatism aberrations that are otherwise present in the probe spots, 291, 292, and 293.

The image-forming element array 222, the aberration compensator array 224, and the pre-bending deflector array 223 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 231 focuses the beamlets onto the surface of the target 208, i.e., it projects the three virtual images onto the target surface. The three images formed by three sub-beams 211 to 213 on the target surface form three probe spots 291, 292 and 293 thereon. In an embodiment the deflection angles of sub-beams 211 to 213 are adjusted to pass through or approach the front focal point of objective lens 231 to reduce or limit the off-axis aberrations of three probe spots 291 to 293. In an arrangement the objective lens 231 is magnetic. Although three beamlets are mentioned, this is by way of example only. There may be any number of beamlets.

In an embodiment a beam separator (not shown) is provided. The beam separator may be downbeam of the source converter 220. The beam separator may be, for example, a Wien filter comprising an electrostatic dipole field and a magnetic dipole field. The beam separator may be upbeam of the objective lens 231. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 204.

In an embodiment a secondary device (not shown) is provided comprising detection elements for detecting corresponding secondary charged particle beams, for example at a remote end of the secondary device which is connected to the main device at a proximate end of the secondary device. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus comprising the secondary device including the associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus, for example close to the proximate end of the secondary device. The secondary projection apparatus subsequently focuses the path of secondary electron beams onto a plurality of detection regions of the electron detection device, for example towards the remote end of the secondary device. The secondary projection apparatus and its associated electron detection device may register and generate an image representation of the target 208 using the secondary electrons or backscattered electrons (or signal particles).

Any element or collection of elements may be replaceable or field replaceable within the charged particle-optical device. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. Such a plate may be manufactured using processing suitable for manufacturing microelectromechanical systems (MEMS); such a charged particle-optical component or device may be referred to being made using such MEMS manufacturing techniques and on occasion may be referred to as a MEMS. MEMS are miniaturized mechanical and electromechanical elements that are made using semiconductor fabricating techniques. Any of the elements and components provided in the source converter may be referred to as MEMS or at least may be made using MEMS manufacturing techniques. In an embodiment, the manipulators such as the lenses and deflectors 222_1, 222_2, and 222_3 are controllable, passively, actively, as a whole array, individually or in groups within an array, so as to control the beamlets of charged particles projected towards the target 208.

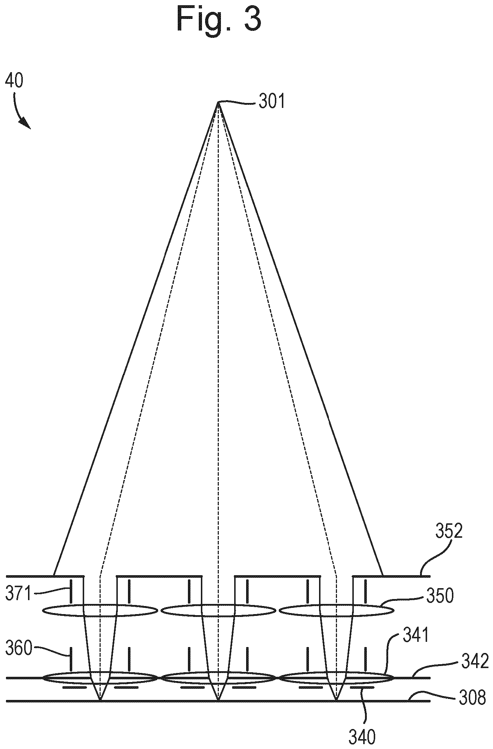

Though not shown, the charged particle-optical device 40 may comprise a collimator element array. For example, the charged particle-optical device 40 may comprise a collimator element array instead of the pre-bending deflector array 223. The collimator element array may comprise a plurality of collimator elements. Each collimator element may be configured to operate on a respective primary beam of the beam grid. The collimator element array may be configured to collimate (or increase the collimation of) the primary beams in the beam grid. Further detail on the structure and function of a collimator element array is provided with reference to **FIG. 3.**

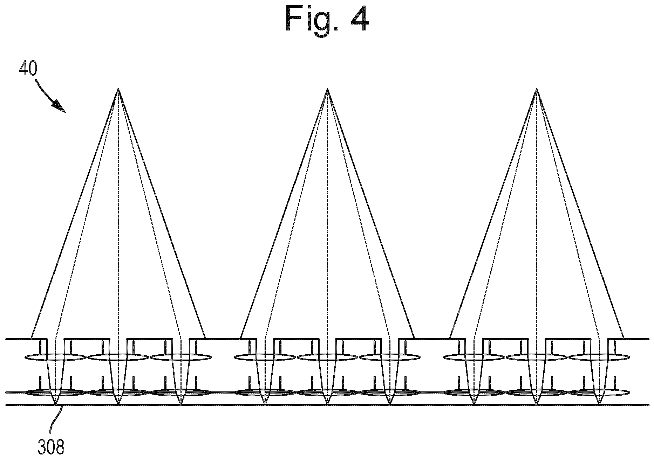

In an embodiment the charged particle-optical device 40 may comprise alternative and/or additional components on the charged particle path, such as lenses and other components some of which have been described earlier with reference to **FIG. 1** and **2.** Examples of such arrangements are shown in **FIG. 3** and **4** which are described in further detail later.

A detector is provided to detect charged particles emitted by the sample. The detector may be integrated into the objective lens. The detector may be situated so as to face a sample in use, for example the detector may be on an end of the charged particle device 40 such as the bottom surface of an objective lens. The detector may comprise an array, for example of detector elements, which may correspond to the array of the primary beams of the beam grid or multibeam arrangement. The detectors (or detector elements) in the detector array may generate detection signals that may be associated with the pixels of a generated image. The condenser lenses, objective lenses and/or detector may be formed as MEMS or CMOS devices and are as such lenses with respect to the different beams of the beam grid. With respect to the beam grid, the condenser lenses, objective lenses and/or detector may be referred to as a condenser lens array, an objective lens array and/or a detector array respectively.

**FIG. 3** is a schematic diagram of another design of an exemplary charged particle-optical device 40. The multibeam charged particle-optical device 40 is an example of the charged particle-optical device 40 of the assessment apparatus 100. The charged particle-optical device 40 may comprise a source 301. Alternatively, the charged particle-optical apparatus (of the assessment apparatus 100) comprises the charged particle-optical device 40 and the source 301, where the source 301 is separate from the charged particle-optical device 40. The charged particle-optical device 40 may comprise an upper beam limiter 352, a collimator element array 371, a control lens array 350, a scan deflector array 360, an objective lens array 341, a beam shaping limiter 342 and a detector array 340. The source 301 provides a beam of charged particles (e.g. electrons), for example as a source beam which may be diverging along the direction towards the sample 308.

The upper beam limiter 352 defines an array of beam-limiting apertures. The upper beam limiter 352 may be referred to as an upper beam-limiting aperture array or an upbeam beam-limiting aperture array. The upper beam limiter 352 may comprise a plate (which may be a plate-like body) in which a plurality of apertures is defined. The upper beam limiter 352 forms the primary beams from the source beam of charged particles emitted by the source 301. As described above, the primary beams may be referred to as sub-beams or beamlets. Portions of the source beam other than those contributing to forming the primary beams may be blocked (e.g. absorbed) by the upper beam limiter 352 so as not to interfere with the primary beams downbeam. The upper beam limiter 352 may be referred to as a primary beam defining aperture array, or a sub-beam defining aperture array.

The collimator element array 371 is provided downbeam of the upper beam limiter 352. Each collimator element array 371 collimates a respective primary beam. The collimator element array 371 may increase a mutual collimation of the plurality of primary beams in the beam grid. That is, the collimator element array 371 may increase the extent to which the plurality of primary beams in the beam grid propagate in the same direction, or reduce a variance in the direction of propagation of the plurality of primary beams across the beam grid. In some embodiments, the operation of the collimator element array on the primary beams of the beam grid is such that the plurality of primary beams in the beam grid are substantially parallel to each other.

The collimator element array 371 may be formed using MEMS manufacturing techniques so as to be spatially compact. In some embodiments, exemplified in **FIG. 3,** the collimator element array 371 is the first deflecting or focusing electron-optical arrangement element in the beam path downbeam of the source 301. In another arrangement, the collimator may take the form, wholly or partially, of a macro-collimator. Such a macro-collimator may be upbeam of the upper beam limiter 352 so it operates on the source beam before generation of the multibeam of primary beams (or beam grid of primary beams). A magnetic lens may be used as the macro-collimator.

Downbeam of the collimator element array there is the control lens array 350. The control lens array 350 comprises a plurality of control lenses. Each control lens comprises at least two electrodes (e.g. two or three electrodes, where each respective electrode is a respective plate in which are defined a plurality of apertures) connected to respective potential sources. The control lens array 350 may comprise two or more (e.g. three) plate electrode arrays connected to respective potential sources. The control lens array 350 is associated with the objective lens array 341 (e.g. the two arrays are positioned close to each other and/or mechanically connected to each other and/or controlled together as a unit).

As mentioned, the control lens array 350 is associated with the objective lens array 341. The control lens array 350 may be considered as providing electrodes additional to electrodes of the objective lens array 341. For example, the control lens array 350 may be considered as part of an objective lens array 341 assembly. The additional electrodes of the control lens array 350 allow further degrees of freedom for controlling the electron-optical parameters of the primary beams. In an embodiment the control lens array 350 may be considered to be additional electrodes of the objective lens array 341 enabling additional functionality of the respective objective lenses of the objective lens array 341. In an arrangement such electrodes may be considered part of the objective lens array providing additional functionality to the objective lenses of the objective lens array 341. In such an arrangement, the control lens is considered to be part of the corresponding objective lens, even to the extent that the control lens is only referred to as being a part of the objective lens for example in terms of providing one more extra degrees of freedom to the objective lens. Although the control lens array 350 may be indistinct from and part of the objective lens array 341, in this description the control lens array 350 is considered to be distinct and separate from the objective lens array 341.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures defined therein. For example, the plates may each comprise apertures for respective primary beams of the beam grid.

The scan-deflector array 360 comprising a plurality of scan deflectors may be provided. The scan-deflector array 360 may be formed using MEMS manufacturing techniques. Each scan deflector scans a respective primary beam over the sample 308. In an embodiment, the scanning deflectors described in EP2425444, which document is hereby incorporated by reference in its entirety specifically in relation to scan deflectors, may be used to implement the scan-deflector array 360.

The objective lens array 341 comprising a plurality of objective lenses is provided to direct the primary beams onto the sample 308. Each objective lens comprises at least two electrodes (e.g. two or three electrodes) connected to respective potential sources.

The objective lens array 341 may form part of an objective lens array assembly along with any or all of the scan-deflector array 360, control lens array 350 and collimator element array 371. The objective lens array assembly may further comprise the beam shaping limiter 342. The beam shaping limiter 342 defines an array of beam-limiting apertures. The beam shaping limiter 342 may be referred to as a lower beam limiter, lower beam-limiting aperture array or final beam-limiting aperture array.

In an arrangement, the beam shaping limiter 342 is structurally integrated with an electrode of the objective lens array 341. Desirably, the beam shaping limiter 342 is positioned in a region of low electrostatic field strength. Each of the beam-limiting apertures is aligned with a corresponding objective lens in the objective lens array 341.

In an embodiment, the charged particle-optical device 40 is configured to control the objective lens array assembly (e.g. by controlling potentials applied to electrodes of the control lens array 350) so that a focal length of the control lenses is larger than a separation between the control lens array 350 and the objective lens array 341. The control lens array 350 and objective lens array 341 may thus be positioned relatively close together, with a focusing action from the control lens array 350 that is too weak to form an intermediate focus between the control lens array 350 and objective lens array 341. The control lens array 350 and the objective lens array 341 operate together to define a combined focal length to the same surface. Combined operation without an intermediate focus may reduce the risk of aberrations. In other embodiments, the objective lens array assembly may be configured to form an intermediate focus between the control lens array 350 and the objective lens array 341.

An electric power source may be provided (not shown) to apply respective potentials to electrodes of the control lenses of the control lens array 350 and the objective lenses of the objective lens array 341.

The detector array 340 is provided to detect charged particles emitted from the sample 308. The detected charged particles may include any of the charged particles (e.g. signal particles) detected by a scanning electron microscope, including secondary (e.g. emitted) and/or backscattered electrons from the sample 308. The detector array 340 may be an array provided on the surface of the charged particle-optical device 40 facing the sample 308, e.g. on the bottom surface of the charged particle-optical device 40. Alternatively (or additionally) the detector array 340 may be upbeam of the bottom surface of the charged particle-optical device 40, for example in or upbeam of the objective lens array 341 or the control lens array 350. The elements of the detector array 340 may correspond to the primary beams of the beam grid. The signal generated by detection of an electron by an element of the detector array 340 may be transmitted to a processor for generation of an image representation of the target 308. The signal may be associated with a pixel of that image.

In other embodiments both a macro scan deflector and the scan-deflector array 360 are provided. In such an arrangement, the scanning of the primary beams over the sample 308 surface may be achieved by controlling the macro scan deflector and the scan-deflector array 360 together, desirably in synchronization.

In an embodiment, as exemplified in **FIG. 4**, there are multiple charged particle optical devices 40, e.g. there is an array of multibeam charged particle-optical devices 40. The array may comprise a plurality of any of the charged particle-optical devices 40 described herein. For example, as shown in **FIG. 4,** the array comprises a plurality of the multibeam charged particle-optical device 40 depicted in **FIG 3.** Each charged particle-optical device 40 of the array focuses respective primary beams simultaneously onto different regions of the same sample.

Any number of charged particle-optical devices 40 may be used in the array. Each charged particle-optical device 40 in the array may be configured in any of the ways described herein when referring to a single charged particle-optical device 40. Details of such an arrangement is described in EPA 20184161.6 filed 6 July 2020 which, with respect to how the objective lens is incorporated and adapted for use in the multi-device arrangement is hereby incorporated by reference.

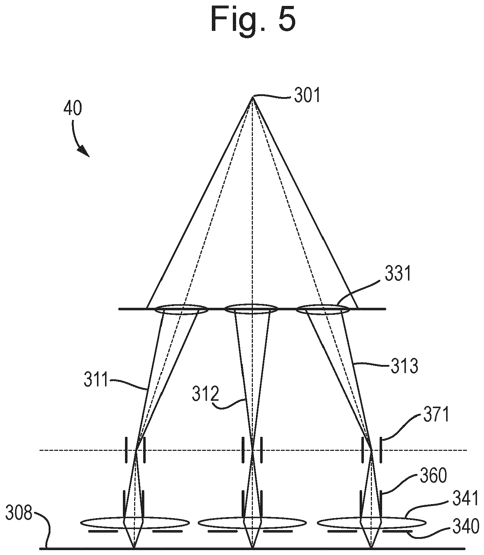

An arrangement of the charged particle-optical device 40 may have the arrangement shown in and described with reference to **FIG. 5**. Same references take the same features and description as supplied with reference to **FIG 3** unless stated to the contrary.

The charged particle-optical device 40 may comprise a condenser lens array 331 upbeam of the objective lens array arrangement 341, as disclosed in EP application 20158804.3 filed on 21 February 2020 which is hereby incorporated by reference so far as the description of the multibeam device with a collimator and its components. The condenser lens array 331 may replace the collimator array 371. The condenser lens array 331 may comprise a plurality of apertures arrays, for example three aperture arrays for an Einzel lens array. The aperture arrays may be electrode plates in which are defined apertures for respective primary beams of the beam grid. The most upbeam aperture array may be a beam limiting aperture array for defining the primary beams of the beam grid from the source beam. The beam limiting aperture array may be upbeam of the most upbeam electrode plate of the condenser lens array 331 or may be the most upbeam electrode plate of the condenser lens array 331. The condenser lens array 331 or its associated beam limiting aperture array may focus the primary beams towards an intermediate focus. The intermediate foci of the different primary beams may be at an intermediate focus plane which may be curved.

The collimator element array 371 may be at or close to the intermediate focus array. The collimator element array 371 may operate on the primary beams to substantially collimate the primary beams. The collimator element array 371 may be one or more deflector arrays and/or lens arrays, in which the constituent aperture arrays are curved and/or are any other suitable collimator array.

The collimator element array 371 may increase a mutual collimation of the plurality of primary beams in the beam grid. That is, the collimator element array 371 may increase the extent to which the plurality of primary beams in the beam grid propagate in the same direction, or reduce a variance in the direction of propagation of the plurality of primary beams across the beam grid. In some embodiments, the operation of the collimator element array on the primary beams of the beam grid is such that the plurality of primary beams in the beam grid are substantially parallel to each other.

The charged particle-optical device 40 shown and described with reference to **FIG. 5** may comprise some of the same features as the charged particle-optical device 40 shown in and described with reference to **FIG. 3.** For example, this may be the case in terms of the objective lens array 341 the scan deflector array 360 and the detector array 340. The charged particle-optical device 40 shown in and described with reference to **FIG. 5** may comprise a control lens array 350 (not shown). The control lens array 350 may be positioned within the charged particle-optical device 40 and configured in the same way as the control lens array of the charged particle-optical device 40 shown in and described with reference to **FIG. 3.** For instance, in the charged particle-optical device 40 shown in and described with reference to **FIG. 5,** a control lens array 350 may be associated with the objective lens array 341 as described with reference to the charged particle-optical device depicted in **FIG. 3.** In an embodiment the control lens array may be comprised by additional plates of the objective lens array 341. The upper beam limiter 352 and the beam shaping limiter 342 of the charged particle-optical device 40 depicted in **FIG. 3** are not necessarily present in the charged particle-optical device 40 depicted in **FIG. 5** because of the presence of the beam limiting aperture array in or associated with the condenser lens array 331.

The detector (or detector array) 340 may be integrated into the objective lens array 341 and the control lens array 350 (when present as it is not depicted in **FIG. 5).** The detector 340 may have more than one detector elements at different positions along the paths of the primary beams of the multibeam, or along the path of the beam grid of the primary beams. In an arrangement the detector array 340 may be the most downbeam surface of the charged particle-optical device 40. In another arrangement, the detector array may be located upbeam of the objective lens array 341, for example upbeam of the control lens array 350, or for example, as part of the control lens array 350. In an arrangement the objective lens arrangement may comprise a separator array, e.g. an electrostatic deflector array and/or a magnetic deflector array, which may cancel the deflection of the other deflections applied to primary beams and may have a cumulative deflection to deflect signal particles towards the detector array 340 for example when the detector array is located above the objective lens arrangement, such as upbeam of or part of the control lens array 350. In an arrangement the detector may be located in similar locations in the charged particle-optical device 40 depicted in **FIG. 5** as described with reference to and as shown in the charged particle-optical device of **FIG. 3.**

A charged particle-optical device array having multiple multibeam devices has been described with reference to the multibeam device of **FIG. 3,** as shown in **FIG. 4.** In another arrangement of a charged particle-optical device array, the charged particle-optical devices 40 may have the same features as the charged particle-optical device described with reference to **FIG. 5.** The multiple multibeam charged particle-optical devices 40 may be arranged in an array of multibeam devices. Such an arrangement is shown and described in EP Application 20158732.6 filed on 21 February 2020 which is hereby incorporated by reference with respect to the multi-device arrangement of a multibeam apparatus featuring the design of multibeam device disclosed with a collimator at, or even proximate to, an intermediate focus. A further alternative design of multibeam apparatus comprises multiple single beam devices.

The charged particle-optical device 40 may be a component of an assessment apparatus 100 (e.g. for inspection, metrology, metro-inspection or any other type of assessment), or part of an e-beam lithography apparatus or other type of charged particle induced sample patterning apparatus. The charged particle optical device 40 may be used in a number of different applications that include electron microscopy in general, not just scanning electron microscopy, such as for assessment applications, and lithography, e.g. electron beam lithography.

As has been explained above, the charged particle-optical device 40 may comprise a collimator element array, for example, the collimator element array 371. The collimator element array may comprise a plurality of collimator elements, which each operate on a respective primary beam of the beam grid. The collimator element array may be configured to collimate the primary beams of the beam grid, or at least increase the mutual collimation of the primary beams of the beam grid. In other words, the collimator element array may be configured to increase an extent to which the plurality of primary beams in the beam grid propagate in the same direction. In other words, the collimator element array may be configured to reduce a variance of the direction in which each of the plurality of primary beams of the beam grid propagate. For example, a collimator element array may receive a plurality of beams which diverge from one another, and may output a plurality of beams in a beam grid which are substantially parallel to each other.

The collimator element array described herein may be implemented in the manner described in relation in the collimator element array 371 depicted in **FIG. 3,** in the manner described in relation to the collimator element array 371 depicted in **FIG. 5,** or in other manners not explicitly described. In general, a collimator element array may be of use at any position within the charged particle-optical device 40 at which it is desirable for the mutual collimation of the plurality of beams in the beam grid to be increased.

Various designs for collimator element arrays have been proposed. However, the designs currently known in the art suffer from several disadvantages.

One proposed design for a collimator element array comprises a plurality of sets of parallel plates. The plurality of sets of parallel plates are arranged sequentially along the optical axis of the charged particle-optical device 40. Each set of parallel plates comprises a plurality of parallel plates. The parallel plates extend in a plane that is parallel to the upbeam/downbeam direction, such that each of the primary beams of the beam grid pass between two of the parallel plates. A collimator element array of this design may comprise, for example, three sets of such parallel plates. Each set of parallel plates may be configured to deflect the primary beams of the beam grid. The plurality of sets of parallel plates may be configured such that the deflections undergone by the plurality of beams of result in the collimation of the plurality of beams of the beam grid.

However, collimator element arrays comprising a plurality of sets of parallel plates suffer from several disadvantages. For example, collimator element arrays comprising a plurality of sets are sensitive to mechanical vibrations. This is because each of the sets of parallel plates has a very large aspect ratio (i.e. a dimension of the parallel plates in the beamwise direction far exceeds a distance between each of the parallel plates in a set of parallel plates).

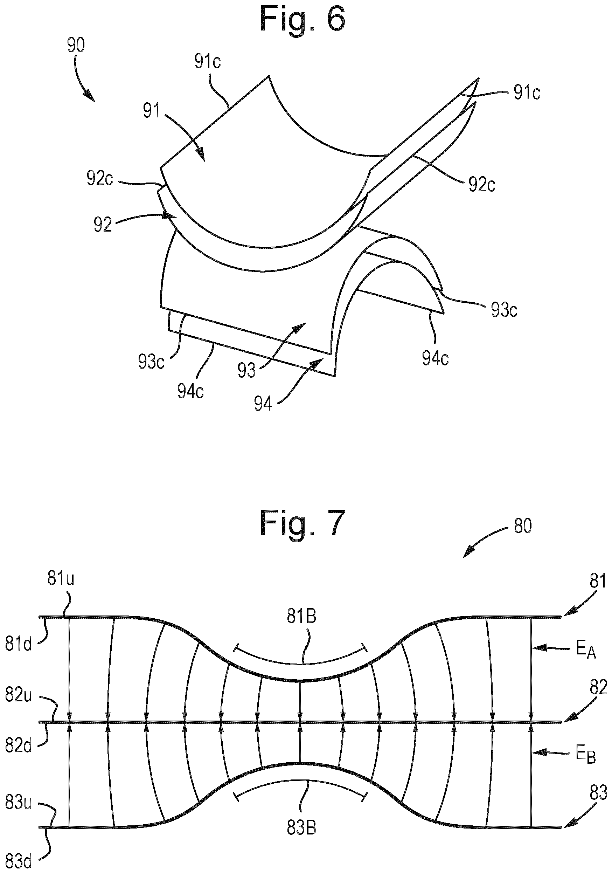

Another proposed design for a collimator element array comprises two pairs of cylindrically curved plates. An example of a collimator element array 90 comprising two pairs of cylindrically curved plates 91, 92, 93, 94 is schematically depicted in **FIG. 6.** The collimator element array 90 comprises a first pair of curved plates 91, 92 and a second pair of curved plates 93, 94. Each of the curved plates 91, 92, 93, 94 comprise a plurality of apertures (not shown) define therein. Each of the plurality of apertures are configured to allow the passage of a primary beam (e.g. one primary beam) of the plurality of beams of the beam grid therethrough.

The first pair of curved plates 91, 92 comprises a first plate 91 and a second plate 92. The first plate 91 and the second plate 92 are each cylindrically curved. The cylindrical curvature of the first plate 91 and second plate 92 may be substantially the same, such that the first plate 91 is substantially parallel to the second plate 92. From a position of the observer upbeam of the first plate 91, the first plate 91 and the second plate 92 would appear to be concave.

To achieve this cylindrical curvature, the first plate 91 and second plate 92 may each be supported (e.g. clamped) at two opposing sides 91c, 92c. The first plate 91 and the second plate 92 may be pre-bent to obtain the desired cylindrical curvature.

The second pair of curved plates 93, 94 comprises a third plate 93 and a fourth plate 94. The third plate 93 and the fourth plate 94 are each cylindrically curved. The cylindrical curvature of the third plate 93 and of the fourth plate 94 may be substantially the same, such that the third plate 93 is substantially parallel to the fourth plate 94. From a position of an observer upbeam of the third plate 93, the third plate 93 and fourth plate 94 appear to be concave.

To achieve this cylindrical curvature, the third plate 93 and fourth plate 94 may each be supported (e.g. clamped) at two opposing sides 93c, 94c. The third plate 93 and the fourth plate 94 may be pre-bent to obtain the desired cylindrical curvature.

The cylindrical curvature of the second pair of curved plates 93, 94 may be substantially perpendicular to the cylindrical curvature of the first pair of plates 91, 92. More specifically, the curvature of each of the plates 91, 92, 93, 94 may have a centre of rotation that is a rotation axis. The rotation axis of the first plate 91 and the second plate 92 may be substantially perpendicular to the rotation axis of the third plate 93 and the fourth plate 94.

A first potential may be applied to the first plate 91. A second potential may be applied to the second plate 92. A third potential may be applied to the third plate 93. A fourth potential may be applied to the fourth plate 94. The second potential, (i.e. the potential applied for the second plate 92) may be less than the first potential (i.e. the potential applied for the first plate 91). Thus, the first pair of parallel plates 91, 92 may act as a decelerating arrangement. The first pair of plates 91, 92 may act to collimate the plurality of primary beams of the beam grid in a first direction. The third potential (i.e. the potential applied to the third plate 93) may be less than the fourth potential (i.e. the potential applied to the fourth plate 94). Thus, the second pair of the plates, 93, 94 may act as an accelerating arrangement. The second pair of plates 93, 94 may act to collimate the plurality of primary beams in a second direction, where the second direction is perpendicular to the first direction. Thus, the combination of the first pair of plates 91, 92 and the second pair of plates 93, 94 may act to collimate the plurality of beams in the beam grid into orthogonal directions (i.e. an x-direction and a y-direction).

In some cases, the first potential may be substantially equal to the fourth potential so that the plurality of primary beams of the beam grid have the same energy exiting the collimator element array as when the plurality of primary beams of the beam grid enter the collimator element array.

A collimator lens array comprising two pairs of curved plates (e.g. as depicted in **FIG. 6)** may be less sensitive to mechanical vibrations than a collimator lens array comprising a plurality of sets of parallel plates. However, collimator lens arrays comprising two pairs of curved plates (e.g. as depicted in **FIG. 6)** suffer from several disadvantages.

First, because the collimation of the plurality of beams of the beam grid occurs sequentially in two orthogonal directions (i.e. first in an x-direction and then in a y-direction), the collimator element array behaves as an anamorphic lens. Thus, if the beam grid is to be symmetrical at the level of the objective lens (i.e. a component downbeam of the collimator element array), the beam grid would need to be asymmetric at the collimator element array (and at any component upbeam of the collimator element array). This asymmetry increases complexity and increases the difficulty of ensuring alignment between apertures of the different components of the charged particle-optical device 40.

Further, the application of a different potentials to the plates of the pairs of plates (i.e. the application of a potential difference between the first plate 91 and the second plate 92, and the application of a potential difference between the third plate 93 and the fourth plate 94) means that substantial electric fields are generated between the plates (i.e. a substantial electric field is generated between the first plate 91 and the second plate 92, and a substantial electric field is generated between the third plate 93 and the fourth plate 94). These electric fields may result in an electrostatic pressure being exerted on the plates 91, 92, 93, 94 (e.g. an electrostatic pressure being exerted on the first plate 91 in a direction of the second plate 92, and an electrostatic pressure being exerted on the second plate 92 in the direction of the first plate 91).

Electrostatic pressure is proportional to the field energy density, $\eta_E$, which in turn is proportional to $E^2$ according to $\eta_E = \frac{1}{2}\varepsilon E^2$ (where $\varepsilon$ is the electric permittivity and E is the electric field strength). The electrostatic pressure thus increases quickly with increasing E.

The electrostatic pressure causes a change in shape and/or position of one or more of the curved plates 91, 92, 93, 94. The change in shape and/or position of the curved plates 91, 92, 93, 94 may be referred to as electrode deformation. The change in shape and/or position of the curved plates 91, 92, 93, 94 may mean that the collimator element array does not work as intended. Further, if the stresses induced in the plates 91, 92, 93, 94 exceeds the yield strength of the material from which they are manufactured (e.g. silicon), the curved plates 91, 92, 93, 94 may fail (e.g. fracture).

The present disclosure is directed to providing a charged particle-optical element. The charged particle-optical element may be for a charged particle beam apparatus. The charged particle-optical element, may be, for example an electron-optical element. That is, the charged particle-optical element may be an element that is configured to operate on a plurality of beams of electrons in a beam grid. For example, the charged particle-optical element may be a component of a scanning electron microscope.

The charged particle-optical element described herein may be configured to collimate a plurality of beams in a beam grid. That is, the charged particle-optical element may be a collimator element array, such as the collimator element array 371 depicted in **FIGS. 3** and **5**. However, the charged particle-optical element described herein is not limited thereto. That is, the charged particle-optical element may be used in a charge particle beam apparatus for purposes other than collimation. In general, it will be recognized that providing a charged particle-optical element of the nature described herein allows for operations to be performed on the beam grid other than collimation. That is, the charged particle-optical element of the present disclosure may be used for general manipulation of the plurality of primary beams of the beam grid which does not result in an increase in the mutual collimation of the plurality of primary beams of the beam grid. For example, the charged particle-optical element of the present disclosure may be used to decrease the mutual collimation of the plurality of primary beams (i.e. to increase a variance in the direction of propagation for the plurality of primary beams). For the charged particle-optical element to decrease the mutual collimation of the plurality of primary beams, the potential differences between the electrodes and/or the curvatures of the electrodes may be adapted.

**FIG. 7** depicts schematic representation of a charged particle-optical element 80 in accordance with an embodiment. The following description may refer to the operation of the charged particle-optical element 80 as a collimator lens array. However, as will be appreciated, the charged particle-optical element 80 may be a charged particle-optical element other than a collimator lens array. The charged particle-optical element 80 is configured to operate on a plurality of beams of charged particles, for example, a plurality of beams of charged particles arranged in a beam grid. The beam grid may be as described above. The charged particle-optical element 80 may be configured to be used in the charged particle-optical device 40 described above and depicted in **FIG. 2** to **FIG. 5.**

In the charged particle-optical element 80 depicted in **FIG. 7** there is a an upbeam electrode 81, an intermediate electrode 82, and a downbeam electrode 83. In the charged particle-optical element 80 depicted in **FIG. 7,** the upbeam electrode 81 is an example of a "first electrode", the intermediate electrode 82 is an example of a "second electrode", and the downbeam electrode is an example of a "third electrode".

The upbeam electrode 81, the intermediate electrode 82 and the downbeam electrode 83 are arranged such that they lie sequentially along the path of the beam grid. Along the path of the beam grid, the upbeam electrode 81 is upbeam of the intermediate electrode 82. Along the path of the beam grid, the downbeam electrode 83 is downbeam of the intermediate electrode 82. The intermediate electrode 82 is interposed between the upbeam electrode 81 and the downbeam electrode 83.

Each of the upbeam electrode 81, the intermediate electrode 82 and the downbeam electrode 83 may be plate. Thus, the upbeam electrode 81 may be referred to as an upbeam plate 81, the intermediate electrode 82 may be referred to as an intermediate plate 82, and the downbeam electrode 83 may be referred to as a downbeam plate 83. For each of the upbeam electrode 81, the intermediate electrode 82 and the downbeam electrode 83, a thickness (i.e. a dimension in the beamwise direction) may be less than (for example, much less than) dimensions in directions that are perpendicular to the beamwise direction.

In each of the upbeam electrode 81, the intermediate electrode 82 and the downbeam electrode 83, there may be defined one or more apertures (not shown). The apertures are not depicted in **FIG. 7** (or the following figures) for simplicity. That is, in the upbeam electrode 81 there may be defined one or more apertures which may be referred to as upbeam apertures. In the intermediate electrode 82 there may be defined one or more apertures which may be referred to as intermediate apertures. In the downbeam electrode 83, there may be defined one or more apertures which may be referred to as downbeam apertures. Each of the apertures (i.e. each upbeam aperture, each intermediate aperture and each downbeam aperture) may be configured to allow the passage of one or more beams of the beam grid therethrough. To pass through the charged particle-optical element 80, each beam in the beam grid may pass through an upbeam aperture (i.e. an aperture in the upbeam electrode 81), an intermediate aperture (i.e. an aperture in the intermediate electrode 82) and a downbeam aperture (i.e. an aperture in the downbeam electrode 83).

The apertures in each of the electrodes 81, 82, 83 may extend between opposing surfaces of the electrodes. That is, the upbeam apertures may extend between an upbeam surface 81u and a downbeam surface 81d of the upbeam electrode 81, the intermediate apertures may extend between an upbeam surface 82u and a downbeam surface 82d of the intermediate electrode 82, and the downbeam apertures may extend between an upbeam surface 83u and a downbeam surface 83d of the downbeam electrode 83.

The apertures in each of the electrodes 81, 82, 83 may be aligned with the plurality of beams of the beam grid. For instance, in the case that the beam grid comprises a plurality of beams in a two-dimensional array, each of the electrodes 81, 82, 83 may comprise a plurality of apertures arranged in a two-dimensional array corresponding to the plurality of beams in the beam grid.

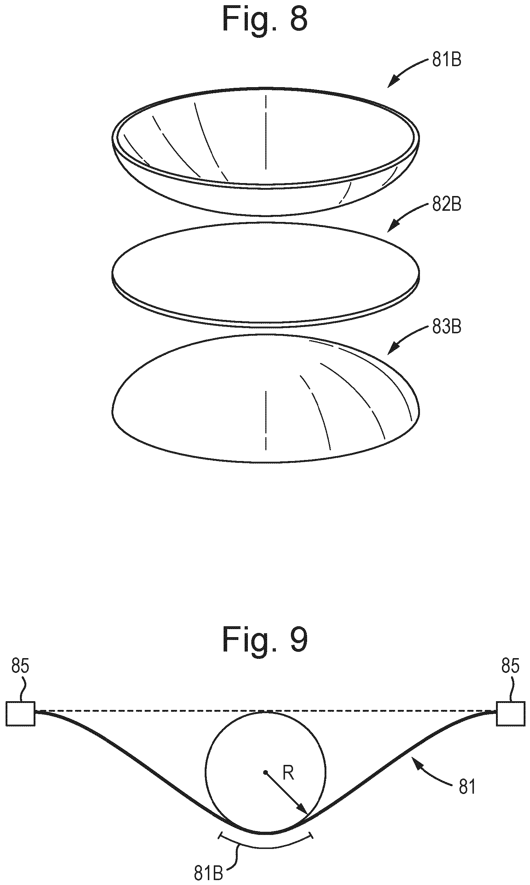

The apertures in each of the electrodes 81, 82, 83 may be provided in a beam area of the electrodes 81, 82, 83. That is, the upbeam apertures may be provided in a beam area 81B of the upbeam electrode 81. The intermediate apertures may be provided in a beam area 82B (see FIG. 8) of the intermediate electrode 82. The downbeam apertures may be provided in a beam area 83B of the downbeam electrode 83. **FIG. 8** schematically depicts the beam areas 81B, 82B, 83B of the upbeam electrode 81, the intermediate electrode 82 and the downbeam electrode 83.

**FIG. 9** schematically depicts the upbeam electrode 81 of the charged particle-optical arrangement depicted in **FIG. 7**. The upbeam electrode 81 is supported at a support portion thereof. The support portion may be an edge portion of the upbeam electrode 81. An unsupported portion of the upbeam electrode 81 may be a portion of the upbeam electrode 81 that is radially inward of the support portion. That is, the unsupported portion of the upbeam electrode 81 may be a portion of the upbeam electrode 81 that is radially inward of the portion of upbeam electrode at which the upbeam electrode 81 is supported. A radially inner boundary of the support portion of the upbeam electrode 81 may be substantially circular. Thus, the unsupported area of the upbeam electrode 81 may be circular. A diameter of the radially inner boundary of the support portion may be greater than 40 mm. The radially inner boundary of the support portion may be concentric with the beam area 81B of the first electrode 81.

As depicted in **FIG. 9,** the support portion of the upbeam electrode 81 is supported by a support member 85. The support portion 81 of the upbeam electrode may be defined by the portion of the upbeam electrode 81 that is supported by the support member 85. The support member 85 may be, for example, a spacer 85. The support member 85 may be, for example, an annular spacer. The support member 85 may extend around substantially all of the radially inner boundary of the support portion.

The support member 85 may extend around the edge of the upbeam electrode 81. In some examples, the support portion of the upbeam electrode extends around substantially all of a perimeter of the upbeam electrode 81.

In some embodiments, the upbeam electrode 81 may be supported by a plurality of support members (not shown). The plurality of support members may be arranged in a substantially circular manner. The plurality of support members may be a plurality of distinct spacer portions which collectively form an annular spacer. There may be gaps (i.e. spaces) between adjacent spacer portions of the plurality of spacer portions. The plurality of spacer portions may collectively define a circular radially inner boundary of the support portion of the upbeam electrode 81. In this case, the upbeam electrode 81 may not be supported around all of the radially inner boundary of the support portion of the upbeam electrode 81.

The intermediate electrode 82 and the downbeam electrode 83 may be supported in the same way as described above in relation to the manner in which the upbeam electrode 81 is supported. In some embodiments, each of the electrodes 81, 82, 83 may be supported in a similar or a corresponding manner. However, as will be appreciated, this is not essential.

The depiction of the charged particle-optical element 80 in **FIG. 7** may be a depiction of the charged particle-optical element 80 in an "activated state". For purposes of the preset disclosure, the term "activated state" may be used to refer to a state of the charged particle-optical element 80 in which the charged particle-optical element 80 is able to operate on the plurality of beams of the beam grid in a desired manner.

In some embodiments, the charged particle-optical element 80 is capable of transitioning between at least the activated state (as depicted in **FIG. 7)** and an "inactivated state". In the inactivated state, the charged particle-optical element 80 may not be able to operate on the plurality of the beams of the beam grid in the desired manner. In transitioning between the activated state and the inactivated state, one or more of the electrodes 81, 82, 83 (e.g. the upbeam electrode 81 and the downbeam electrode 83) may be deformed. This will be described in further detail below.

The structure and function of the charged particle-optical element 80 in the activated state will now be described. In the activated state, one or more of the electrodes 81, 82, 83 adopt a target curved profile. For example, the upbeam electrode 81 and the downbeam electrode 83 may adopt a target curved profile. The intermediate electrode 82 may for example remain substantially flat.

In the activated state, the upbeam electrode 81 may curve towards the intermediate electrode 82 to achieve a target curved profile. That is, a distance between a radially inner portion of the upbeam electrode 81 (e.g. a portion of the unsupported area of the upbeam electrode 81) and a corresponding radially inner portion of the intermediate electrode 82 (e.g. a portion of the unsupported area of the intermediate electrode 82) may be less than a distance between a radially outer portion of the upbeam electrode 81 (e.g. a portion of the support portion of the upbeam electrode 81) and a corresponding radially outer portion of the intermediate electrode 82 (e.g. a portion of the support portion of the intermediate electrode 82). For an observer at a position upbeam of the upbeam electrode 81, the upbeam electrode 81 is concave.

In the activated state, the downbeam electrode 83 may curve towards the intermediate electrode 82 to achieve a target curved profile. That is, a distance between a radially inner portion of the downbeam electrode 83 (e.g. a portion of the unsupported area of the upbeam electrode 83) and a corresponding radially inner portion of the intermediate electrode 82 (e.g. a portion of the unsupported area of the intermediate electrode 82) may be less than a distance between a radially outer portion of the downbeam electrode 83 (e.g. a portion of the support portion of the downbeam electrode 83) and a corresponding radially outer portion of the intermediate electrode 82 (e.g. a portion of the support portion of the intermediate electrode 82). For an observer at a position downbeam of the downbeam electrode 83, the downbeam electrode 83 is concave.

As shown schematically in **FIG. 9,** a target curved profile of the upbeam electrode 81 may be such that curvature of the beam area 81B of the upbeam electrode 81 is substantially spherical. In the context of the present disclosure, "is substantially spherical" may mean "can be approximated as spherical". The target curved profile of the downbeam electrode 83 may be such that curvature of the beam area 83B of the downbeam electrode 83 is substantially spherical. In some embodiments, the target curvature of the beam area 81B of the upbeam electrode 81 is spherical and the target curvature of the beam area 83B of the downbeam electrode 83 is spherical.

Providing electrodes 81, 83 in the charged particle-optical element 80 having beam areas with substantially spherical curvature allows collimation of the plurality of beams in the beam grid to occur in two orthogonal directions simultaneously, wherein the two orthogonal directions are each orthogonal to the beamwise direction. That is, in the charged particle-optical element 80 depicted in **FIG. 7,** it is not the case that the plurality of beams of the beam grid are collimated in one direction by a first set of plates and then collimated in another direction by a second set of plates (as in known collimator lens array arrangements, such as the collimator lens array depicted in **FIG. 6** and described above). Consequently, the beam grid may be symmetrical at the charged particle-optical element 80 (and at other charged particle-optical elements) positioned upbeam of the charged particle-optical element 80 in the charged particle-optical device 40. Thus, complexity of the charged particle-optical element 80 (and of the charged particle-optical device 40 in general) is reduced. Further, alignment of different apertures in different electrodes of the charged particle-optical element 80 may be simpler.

In the activated state, different potentials (i.e. voltages) are applied to the electrodes 81, 82, 83 of the charged particle-optical element 80. For example, a first potential may be applied to the upbeam electrode 81, a second potential may be applied to the intermediate electrode 82 and a third potential may be applied to the downbeam electrode 83.

The first potential may be different to the second potential. Thus, there may exist a potential difference between the upbeam electrode 81 and the intermediate electrode 82. Consequently, an electric field $E_A$ is present between the upbeam electrode 81 and intermediate electrode 82. Specifically, the electric field $E_A$ exists between facing surfaces 81d, 82u of the upbeam electrode 81 and the intermediate electrode 82 (i.e. the downbeam surface 81d of the downbeam electrode 81 and the upbeam surface 82u of the intermediate electrode 82). The potential difference between the upbeam electrode 81 and the intermediate electrode 82 may be between 1 kV and 100 kV, e.g. 25 kV. Similarly, the third potential may be different to the second potential. Thus, there may exist a potential difference between the downbeam electrode 83 and the intermediate electrode 82. As the result of this potential difference, there may exist an electric field $E_B$ between the downbeam electrode 83 and the intermediate electrode 82. Specifically, the electric field $E_B$ exists between facing surfaces 82d, 83u of the intermediate electrode 82 and the downbeam electrode 83 (i.e. the downbeam surface 82d of the intermediate electrode 82 and the upbeam surface 83u of the downbeam electrode 82). The potential difference between the intermediate electrode 82 and the downbeam electrode 83 may be between 1 kV and 100 kV, e.g. 25 kV.

The target curvature of the upbeam electrode 81 results in a curvature in the electric field $E_A$ between the upbeam electrode 81 and the intermediate electrode 82. For the purposes of the following description, a lateral direction is a direction that is perpendicular to the beamwise direction. The curvature of the electric field $E_A$ may mean that a lateral force is exerted on some of the beams in the beam grid as the beams pass between the upbeam electrode 81 and the intermediate electrode 82. The target curvature of the downbeam electrode 83 results in a curvature of the electric field $E_B$ between the intermediate electrode 82 and the downbeam electrode 83. The curvature of the electric field $E_B$ may mean that a lateral force is exerted on some of the beams in the beam grid as the beams pass between the intermediate electrode 82 and the downbeam electrode 83. In **FIG. 7,** field lines $E_A$, $E_B$ indicate the direction in which a force on a positively charged particle in the electric field will be exerted. The force exerted on a negatively-charged particle (e.g. an electron) would be in a direction opposite to the direction of the field lines $E_A$, $E_B$.

In some embodiments, the first potential is greater than the second potential. This means that the charged particles in the plurality of beams of the beam grid decelerate (in the beamwise direction) as the charged particles in the plurality of beams of the beam grid pass between the upbeam electrode 81 and the intermediate electrode 82. In other words, energies of the charged particles in the plurality of beams of the beam grid decrease as the charged particles of the plurality of beams of the beam grid pass between the upbeam electrode 81 and the intermediate electrode 82. In some embodiments, the third potential is greater than the second potential. This means that the charged particles in the plurality of beams of the beam grid accelerate (in the beamwise direction) as the charged particles in the plurality of beams of the beam grid pass between the intermediate electrode 82 and the downbeam electrode 83. In other words, energies of the charged particles in the plurality of beams of the beam grid increase as the plurality of beams of the beam grid pass between the intermediate electrode 82 and the downbeam electrode 83.

In some embodiment, the first potential is substantially equal to the third potential. This means that the charged particles in the plurality of beams of the beam grid have substantially the same energy when entering the charged particle-optical device 80 as when the exiting the charged particle-optical device 80. In this way, the charged particle-optical device 80 may be an Einzel lens arrangement.

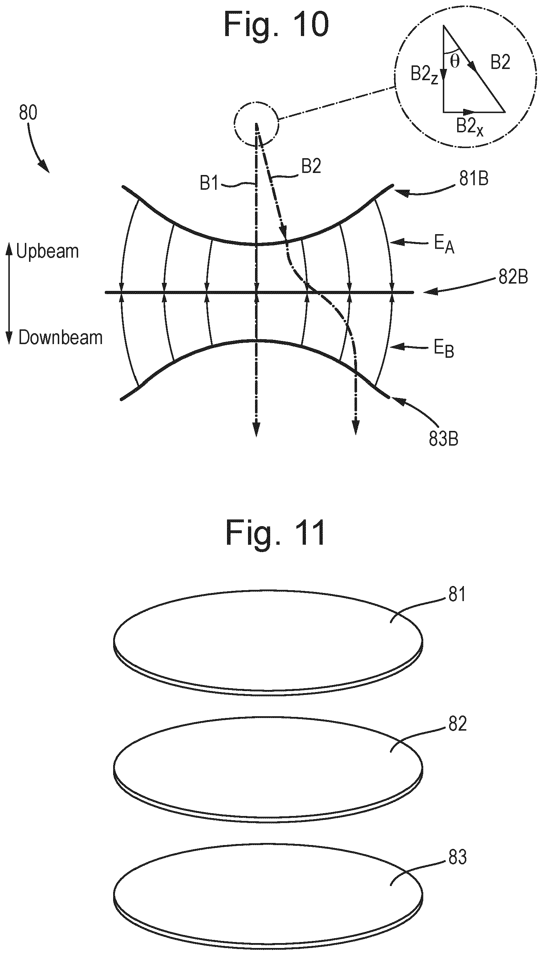

The operation of the charged particle-optical element 80 on the plurality of beams of the beam grid will now be described with reference to **FIG. 10.** In the following description, the charged particle-optical element 80 operates on the charged particles in the plurality of beams of the beam grid to collimate the plurality of beams of the beam grid. However, it will be recognized that the charged particle-optical element 80 may operate on the charged particles in the plurality of beams of the beam grid to manipulate the plurality of beams of the beam grid in other ways.

**FIG. 10** schematically depicts the passage of two beams of the plurality of beams of the beam grid) through the charged particle-optical element 80. Specifically, **FIG. 10** schematically depicts passage of a first beam B1 and a second beam B2 through the charged particle-optical element 80. Before passing through the charged particle-optical arrangement, the first beam B1 is parallel to the optical axis (or beamwise direction) of the charged particle-optical device 40. In other words, the charged particles in the first beam may propagate in the downbeam direction. The first beam B1 may be a middle beam of the plurality of beams of the beam grid. Before passing through the charged particle-optical arrangement, the second beam B2 is not parallel to the optical axis (or beamwise direction) of the charged particle-optical device 40. In other words, there may a non-zero angle $\theta$ between the direction in which the charged particles in the second beam B2 propagate and the optical axis (or beamwise direction) of the charged particle-optical device 40. The angle between the direction in which the charged particles in the second beam B2 propagate and the optical axis (or beamwise direction) may be referred to as an off-axis angle of the second beam B2. For completeness, the off-axis of the first beam B1 is substantially zero.

The first beam B1 passes through a radial center of the charged particle-optical element 80. The path of the first beam B1 does not change as the first beam B1 passes through the charged particle-optical element 80. That is, a direction of propagation of the charged particles in the first beam B1 before entering the charged particle-optical arrangement 80 may be substantially the same as a direction of propagation of the charged particles in the first beam B2 after exiting the charged particle-optical arrangement 80. This may be because a direction of the electric fields $E_A$, $E_B$ is substantially parallel to the direction of propagation of the charged particles in the first beam B1. Thus, the charged particles in the first beam B1 may decelerate between the upbeam electrode 81 and the intermediate electrode 82, and may accelerate between the intermediate electrode 82 and the downbeam electrode 83. However, the charged particles in the first beam B1 may not accelerate or decelerate in the lateral direction, because no lateral forces are exerted on the charged particles in the first beam B1.

The second beam B2 does not pass through the radial center of the charged particle-optical element 80. In **FIG. 10,** the second beam B2 enters the charged particle-optical element 80 at a position radially outward of the radial center of the charged particle-optical element 80. When entering the charged particle-optical element 80, the velocity of the charged particles in the second beam B2 have a downbeam component $B2_z$ and a radial component $B2_x$. the radial component $B2_x$ is a radially outward component (i.e. a component pointing away from the center of the charged particle-optical element 80.

Between the upbeam electrode 81 and the intermediate electrode 82 (and away from the radial center of the charged particle-optical element 80) the electric field $E_A$ is curved. That is, the electric field has a component in the beamwise direction and a component in the radial direction. In the case that the first potential is greater than the second potential (as described above), the curvature of the electric field $E_A$ is such that the charged particles in the second beam B2 experience a force with a component in the upbeam direction and a component in the radially inward direction. This causes the charged particles in the second beam B2 to decelerate in the beamwise direction (i.e. accelerate in the upbeam direction) and to accelerate in the radially inward direction. The acceleration of the charged particles in the second beam B2 in the radially inward direction reduces the magnitude of the radially outward component of the velocity of the charged particles in the second beam B2. However, the acceleration of the charged particles in the second beam B2 in the upbeam direction may mean that, when the second beam B2 reaches the intermediate electrode 82, the off-axis angle is increased (relative to the off-axis angle of the second beam B2 when the second beam B2 enters the charged particle-optical element 80).

Between the intermediate electrode 82 and the downbeam electrode 83 (away from the radial center of the charged particle-optical element 80) the electric field $E_B$ is curved. That is, the electric field $E_B$ has a component in the beamwise direction and a component in the radial direction. In the case that the third potential is greater than the second potential (as described above), the curvature of the electric field $E_B$ is such that the charged particles in the second beam B2 experience a force with a component in the downbeam direction and a component in the radially inward direction. This causes the charged particles in the second beam B2 to accelerate in the downbeam direction and to accelerate in the radially inward direction. The acceleration of the charged particles in the second beam B2 in the radially inward direction reduces the magnitude of the radially outward component of the velocity of the charged particles in the second beam B2. Further, as the second beam B2 passes from the intermediate electrode 82 to the downbeam electrode 83, the acceleration of the charged particles in the second beam B2 in the downbeam direction may mean that the increase in the off-axis angle between the upbeam electrode 81 and the intermediate electrode 82 is at least partially reversed.

As explained above, between the upbeam electrode 81 and the intermediate electrode 82, and between the intermediate electrode 82 and the downbeam electrode 83, the charged particles in the second beam B2 experience a radially inward force. This radially inward force accelerates the charged particles in the second beam B2 in the radially inward direction. The acceleration of the charged particles in the second beam B2 in the radially inward direction may be such that, by the time the second beam B2 reaches the downbeam electrode 83, a radial component of the velocity of the charged particles in the second beam B2 is substantially zero. That is, by the time that the second beam B2 reaches the downbeam electrode 83, the charged particles in the second beam B2 are propagating in the downbeam direction (i.e. a direction which is parallel to the first beam B1 and/or parallel to the optical axis of the charged particle-optical device 40).

All of the beams of the beam grid that do not pass through the radial center of the charged particle-optical element 80 may be operated on by the charged particle-optical element 80 in the manner described above with reference to the second beam B2. In this way, the plurality of beams of the beam grid may be collimated (i.e. a mutual collimation of the plurality of beams of the beam grid may be increased).

In some embodiments, the charged particle-optical element 80 transitions to the activated state (e.g. from the inactivated state) upon the application of the first potential to the upbeam electrode 81, the second potential to the intermediate electrode 82 and the third potential to the downbeam electrode 83. That is, upon application of the first potential to the upbeam electrode 81, the second potential to the intermediate electrode 82 and the third potential to the downbeam electrode 83, the upbeam electrode 81 may adopt the target curved profile and the downbeam electrode 83 may adopt the target curved profile.

The upbeam electrode 81 may adopt the target curved profile by deforming in response to an electrostatic pressure which is exerted on the downbeam surface 81d of the upbeam electrode. The electrostatic pressure arises from the electric field $E_A$. The electrostatic pressure deforms the unsupported area of the upbeam electrode 81 in the direction of the intermediate electrode 82. In other words, the electrostatic pressure deforms the unsupported area of the upbeam electrode 81 in the downbeam direction. The electric field $E_A$ also results in the exertion of an electrostatic pressure on the upbeam surface 82u of the intermediate electrode 82.

The downbeam electrode 83 may adopt the target curved profile by deforming in response to an electrostatic pressure which is exerted on the upbeam surface 83u of the downbeam electrode 83. The electrostatic pressure arises from the electric field $E_B$. The electrostatic pressure deforms the unsupported area of the downbeam electrode 83 in the direction of the intermediate electrode 82. In other words, the electrostatic pressure deforms the unsupported area of the downbeam electrode 83 in the upbeam direction. The electric field $E_B$ also results in the exertion of an electrostatic pressure on the downbeam surface 82d of the intermediate electrode 82.

In some embodiments, the electrostatic pressure exerted on the upbeam surface 82u of the intermediate electrode as a result of the electric field $E_A$ is substantially the same as the electrostatic pressure exerted on the downbeam surface 82d of the intermediate electrode 82 as a result of the electric field $E_B$. Consequently, the resultant force on the intermediate electrode 82 may be substantially zero. Thus, the intermediate electrode 82 may not be deformed upon the application of the first potential, the second potential and the third potential. In other embodiments, electrostatic pressure exerted on the upbeam surface 82u of the intermediate electrode as a result of the electric field $E_A$ is not substantially the same as the electrostatic pressure exerted on the downbeam surface 82d of the intermediate electrode 82 as a result of the electric field $E_B$. In such embodiments, the intermediate electrode 82 may remain substantially flat as a result of the intermediate electrode 82 having a high stiffness (for example a stiffness that is much higher than the stiffness of the upbeam electrode 81 and/or the downbeam electrode 83).

In some embodiments, the deformation of the upbeam electrode 81 and the downbeam electrode 83 as a result of the electric fields $E_A$, $E_B$ may be solely responsible for the curved profile of the upbeam electrode 81 and the downbeam electrode 83 of the charged particle-optical element 80 in the activated state. In this case, in the inactivated state, the upbeam electrode 81 and the downbeam electrode 83 may be substantially flat, as depicted in **FIG. 11.** Applying the first potential, the second potential and the third potential to the charged particle-optical element 80 (e.g. to the flat upbeam electrode 81, the flat intermediate electrode 82 and the flat downbeam electrode 83 shown in **FIG. 11)** may cause the upbeam electrode 81 and the downbeam electrode 83 to adopt a curved profile (as shown in **FIG. 7).**

In some embodiments, the curved profile of the upbeam electrode 81 and the downbeam electrode 83 may not be a result of deformation caused by the electric fields $E_A$, $E_B$. That is, the upbeam electrode 81 and the downbeam electrode 83 may have a curved profile in the inactivated state (i.e. when the first potential, the second potential and the third potential are not applied). In some embodiments, the profile of the upbeam electrode 81 and the downbeam electrode 83 may be substantially unchanged between the activated state and the inactivated state. This may be the case where the upbeam electrode 81, the intermediate electrode 82 and the downbeam electrode 83 are provided in a pre-bent shape. That is, the electrodes 81, 82, 83 may be formed (e.g. molded or machined) to have a target curvature before being installed in the charged particle-optical element 80. A stiffness of the electrodes (i.e. a stiffness of the upbeam electrode 81 and the downbeam electrode 83) may be such that the application of the first potential, the second potential and the third potential (and the resulting fields $E_A$, $E_B$) does not cause a substantial change to the shape of the electrodes 81, 83.

In some embodiments, the deformation of the upbeam electrode 81 and the downbeam electrode 83 as a result of the electric fields $E_A$, $E_B$ may be partly responsible for the curved profile of the upbeam electrode 81 and the downbeam electrode 83 of the charged particle-optical element 80 in the activated state. For example, the upbeam electrode 81 and the downbeam electrode 83 may be provided in the pre-bent shape with curvature which differs from the target curvature. The application of the first potential, the second potential and the third potential may change (e.g. increase) the curvature, such that the target curvature is obtained (or such that a difference between the curvature of an electrode 81, 83 and a target curvature for that electrode 81, 83 is decreased).

A radius of the curvature of the beam area 81B of the upbeam electrode 81 may be less than 100 mm. For example, the radius of the curvature of the beam area 81B of the upbeam electrode 81 may be less than 70 mm, and optionally less than 60 mm. This may allow the charged particle-optical element 80 to provide a desired collimating effect. In some embodiments, the radius of the curvature of the beam area of the upbeam electrode is greater than 50 mm. A curvature of the beam area of the upbeam electrode 81 that is less than 50 mm may introduce excessive complexity. Similarly, a radius of the curvature of the beam area 83B of the downbeam electrode 83 may be less than 100mm. For example, the radius of the curvature of the beam area 83B of the downbeam electrode 83 may be less than 70mm and less than 60mm. The radius of the curvature of the beam area 83B of the downbeam electrode 83 may be greater than 50mm.

To achieve the target curvature of the beam area 81B of the upbeam electrode 81 upon the application of the first potential and the second potential, a stiffness of the upbeam electrode 81 may be adapted. To achieve the target curvature of the beam area 83B of the downbeam electrode 83 upon the application of the second potential and the third potential, a stiffness of the downbeam electrode 83 may be adapted. For example, it may be preferable for a stiffness of the upbeam electrode 81 and/or the downbeam electrode 83 to be relatively small so that the electrostatic pressures exerted on the upbeam electrode 81 and the downbeam electrode 83 are able to cause the upbeam electrode 81 and the downbeam electrode 83 to adopt the target curvatures. Generally, it may be desirable to decrease the stiffness of electrodes 81, 83 which are configured to be deformed in the activated state. Thus, the following description of techniques for reducing the stiffness of electrodes may apply to any electrode that is configured to be deformed in the activated state.

A stiffness of the upbeam electrode 81 may be decreased by decreasing a (local) thickness of the upbeam electrode 81. The thickness of the upbeam electrode 81 may, for example, be locally adapted at or around the beam area 81B. In some embodiments, a (local) thickness of the upbeam electrode is less than 100 mm. In some embodiments, the thickness of the upbeam electrode is less than 50 mm. Providing an upbeam electrode 81 with a thickness that is less than the values stated above may allow the electrostatic pressure exerted on the downbeam surface 81d of the upbeam electrode to deform the upbeam electrode 81 sufficiently for the upbeam electrode 81 to adopt the target curvature (e.g. for the beam area 81B of the upbeam electrode to become spherically curved with a curve radius that is less than 100 mm).

A stiffness of the downbeam electrode 83 may be decreased by decreasing a (local) thickness of the downbeam electrode 83. The thickness of the downbeam electrode 83 may, for example, be locally adapted at or around the beam area 83B. In some embodiments, a thickness of the downbeam electrode 83 is less than 100 mm. In some embodiments, the thickness of the downbeam electrode 83 is less than 50 mm. Providing a downbeam electrode 83 with a thickness that is less than the values stated above may allow the electrostatic pressure exerted on the upbeam surface 83u of the downbeam electrode 83 to deform the downbeam electrode 83 sufficiently for the downbeam electrode 83 to adopt the target curvature (e.g. for the beam area 83B of the downbeam electrode 83 to become spherically curved with a curve radius that is less than 100 mm).

A thickness of the upbeam electrode 81 and/or the downbeam electrode 83 may be greater than 25 $\mu$m. Manufacturing electrodes with a thickness that is less than 25$\mu$m may present numerous issues, and thus may be difficult in practice.

In some embodiments, various adaptations may be made to the electrodes 81, 83 which are configured to be deformed to the target curvature (e.g. the upbeam electrode 81 and the downbeam electrode 83). As described above, the upbeam electrode 81 comprises a beam area 81B through which the apertures are defined. Around the beam area 81B of the upbeam electrode 81 (i.e. radially outward of the beam area 81B of the upbeam electrode 81) there may be a peripheral portion of the upbeam electrode 81. The peripheral portion of the upbeam electrode 81 may be disposed between the beam area 81B of the upbeam electrode 81 and the support portion of the upbeam electrode 81. A thickness beam area 81B of the upbeam electrode 81 may be less than a thickness of the peripheral portion of the upbeam electrode 81. Reducing a thickness of the upbeam electrode 81 in the beam area 81B may decrease the stiffness of the upbeam electrode 81 in the beam area 81B, and thus the application of the potential difference between the upbeam electrode 81 and the intermediate electrode 82 may result in a greater deformation of the beam area 81B of the upbeam electrode 81. This may be such that the desired curvature of the beam area 81B of the upbeam electrode 81 is obtained. A reduction in the thickness in the beam area 83B relative to a peripheral portion/area may also be applied to the downbeam electrode 83, or any other electrode that is configured to be deformed in the activated state.

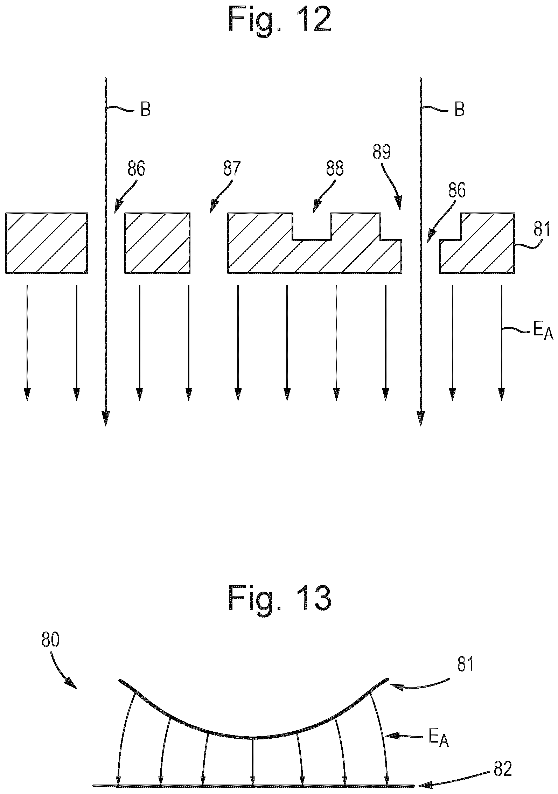

**FIG. 12** depicts an upbeam electrode comprising a plurality of features configured to adapt the stiffness of the electrode. In some examples, a plurality of holes or cut-outs 87 may be provided in the upbeam electrode 81. The holes or cut-outs 87 may be provided in order to reduce the local stiffness of the upbeam electrode 81. The holes or cuts 87 may be separate, and in addition to, the apertures 86 through which the plurality of beams of the beam grid pass through. That is, the holes and or cut-outs 87 referred to here may not be configured to allow the passage of beams B therethrough. Consequently, the holes and or cut outs 87 may be not aligned with the plurality of beams B of the beam grid. The holes or cut-outs 87 may be provided in the beam area 81B of the upbeam electrode 81, or in the peripheral portion of the upbeam electrode 81.

In addition to, or instead of, holes or cut outs 87, one or more recessed portions 88 may be provided in the upbeam electrode 81. The recessed portions 88 may otherwise be referred to as blind holes (i.e. holes which do not extend through the full thickness of the upbeam electrode 81). As with the holes or cut outs 87, the recessed portions 88 may be provided to locally reduce a stiffness of the upbeam electrode 81. This may be so that the desired curvature of the upbeam electrode 81 is obtained upon the application of the first potential and the second potential. In some embodiments, recessed portions 88 may be preferable because they have less of an effect on the field $E_A$ between the upbeam electrode 81 and the intermediate electrode 82 compared to holes or cut outs.

In some examples, recessed portions 89 are provided around one or more of the apertures 86. For instance, an annular (or differently shaped) recessed portion 89 may run around the perimeter of an aperture 86.

The features described above in relation to the upbeam electrode 81 (i.e. the holes or cut-outs and recessed portions) may be applied equally to the downbeam electrode 83. Further, the features described above in relation to the upbeam electrode 81 (i.e. the holes or cut-outs and recessed portions) may be applied equally to any electrode that is configured to be deformed (e.g. to adopt a target curved profile) in the activated state.

In some embodiments, the charged particle-optical arrangement 80 may be substantially symmetrical about that intermediate electrode 82. That is, in the activated state, the upbeam electrode 81 may be a mirror image of the downbeam electrode 83. To achieve this, the upbeam electrode 81 may have substantially the same properties as the downbeam electrode 83, and the first potential may equal the third potential.

In some examples, the charged particle-optical element 80 further comprises one or more actuators (not shown). The one or more actuators may be configured to apply a force to the upbeam electrode 81. The curved profile adopted by the upbeam electrode 81 in the activated state may be at least in part a result of a force exerted on the upbeam electrode 81 by the one or more actuators. The one or more actuators may also comprise actuators configured to apply a force to the downbeam electrode 83. The curved profile adopted by the downbeam electrode 83 in the activated state may be at least in part a result of a force exerted on the downbeam electrode 83 by the one or more actuators.

In some embodiments, the curved target profile adopted by the upbeam electrode 81 in the activated state is at least in part a result of a pre-deformation of the upbeam electrode 81. The pre-deformation of the upbeam electrode 81 may be a permanent deformation in the upbeam electrode 81, e.g. a permanent deformation arising from a bending or forming process performed during the manufacture of the upbeam electrode 81. Additionally or alternatively, the pre-deformation of the upbeam electrode 81 may be a result of a gravitational force acting on the upbeam electrode 81. In some embodiments, the curved profile adopted by the upbeam electrode 81 may be a result of a combination of the pre-deformation of the upbeam electrode 81 and the electrostatic pressure exerted on the upbeam electrode 81 (i.e. the electrostatic pressure exerted on the upbeam electrode as a result of the potential difference between the upbeam electrode 81 and the intermediate electrode 82).

Similarly, in some embodiments, the target curved profile adopted by the downbeam electrode 83 in the activated state is at least in part a result of a pre-deformation of the downbeam electrode 83. The pre-deformation of the downbeam electrode 83 may be a permanent deformation in the downbeam electrode 83, e.g. a permanent deformation arising from a bending or forming process performed during the manufacture of the downbeam electrode 83. Additionally or alternatively, the pre-deformation of the downbeam electrode 83 may be a result of a gravitational force acting on the downbeam electrode 83. In some embodiments, the curved profile adopted by the downbeam electrode 83 may be a result of a combination of the pre-deformation of the downbeam electrode 83 and the electrostatic pressure exerted on the downbeam electrode 83 (i.e. the electrostatic pressure exerted on the downbeam electrode 83 as a result of the potential difference between the downbeam electrode 83 and the intermediate electrode 82). In general, any electrode that is configured to be deformed (e.g. to adopt a target curved profile) in the activated state may be pre-deformed in the manner described above.

As explained above, the upbeam electrode 81 may be supported by a support member 85. The support member 85 may be an annular spacer which extends (at least partially) around the circumference of the upbeam electrode 81. An inner diameter of the annular spacer may define the boundary of the unsupported area of the upbeam electrode 81. The inner diameter of the annular spacer may be greater than 40mm. Increasing the inner diameter of the annular spacer may increase the extent to which the upbeam electrode 81 deforms in response to the application of the first potential and the second potential. Thus, by providing a charged particle-optical element 80 in which an inner diameter of the annular spacer is greater than 40 mm, a desired curvature (the target curvature) for the beam area 81B of the upbeam electrode 81 may be obtained upon the application of the first potential and the second potential. The downbeam electrode 83 may also be supported by an annular spacer with an inner diameter of greater than 40 mm.

In some examples, the electrodes (i.e. the upbeam electrode 81, the intermediate electrode 82 and the downbeam electrode 83) may be formed from a material comprising silicon. For example, one or more of the upbeam electrode 81, the intermediate electrode 82 and the downbeam electrode 83 may be formed from a material substantially comprising silicon. For example, one or more of the upbeam electrode 81, the intermediate electrode 82 and the downbeam electrode 83 may be formed from a material consisting essentially of silicon. For example, one or more of the upbeam electrode 81, the intermediate electrode 82 and the downbeam electrode 83 may be formed from a material consisting of silicon. The silicon may be porous silicon.

The upbeam electrode 81, the intermediate electrode 82 and the downbeam electrode 83 may be formed from a conductive or semi-conductive material. Non-conducting (i.e. insulative) materials, such as glasses and ceramics may also be used for the electrodes 81, 82, 83. However, in this case, it may be necessary to provide a conductive coating (not shown) on the non-conductive material of the electrode 81, 82, 83.

The charged particle-optical element 80 may be part of a system. The system may comprise a power source and a controller (e.g. the controller 50 of the assessment apparatus 100 as introduced in **FIG. 1).** The controller may be configured to control the power source to apply the first potential to the upbeam electrode 81, the second potential to the intermediate electrode 82 and the third potential to the downbeam electrode 83. In other words, the controller may be configured to control the power source to apply the potential difference between the upbeam electrode 81 and the intermediate electrode 2, and to apply the potential difference between the intermediate electrode 82 and the downbeam electrode 83.

As described above, the extent of the collimation of the plurality of beams of the beam grid passing through the charged particle-optical element 80 depends on at least two parameters: 1) the curvature of the upbeam electrode 81 and the curvature of the downbeam electrode 83; and 2) the potential difference between the upbeam electrode 81 and the intermediate electrode 82, and the potential difference between the intermediate electrode 82 and the downbeam electrode 83. The curvature of the upbeam electrode 81 is dependent on the potential difference between the upbeam electrode 81 and the intermediate electrode 82, and the curvature of the downbeam electrode 83 is dependent on the potential difference between the intermediate electrode 82 and the downbeam electrode 83. Thus, by controlling the first potential, second potential and the third potential, both parameters which affect the collimation of the plurality of beams to the beam grid can be controlled. Thus, the operation of the charged particle-optical element can be controlled by varying the first potential, second potential and third potential.

In some examples, the second potential (i.e. the potential applied to the intermediate electrode 82) is controlled to control the operation of the charged particle-optical element 80. For instance, if it is determined that the charged particle-optical element is not operating on the plurality of beams in the beam grid to collimate the plurality of beams (e.g. if the plurality of beams of the beam grid remain divergent after the beam grid passes through the charged particle-optical element 80) the second potential can be reduced. This increases the potential difference between the intermediate electrode 82 and the upbeam electrode 81, and the potential difference between the intermediate electrode 82 and the downbeam electrode 83. This increases the magnitude of the electric fields $E_A$, $E_B$. This decreases the radius of curvature of the upbeam electrode 81 and the downbeam electrode 83 (i.e. makes the upbeam electrode 81 and downbeam electrode 83 more curved). The increase in the magnitude of the electric fields $E_A$, $E_B$ and the decrease in the radius of curvature of the upbeam electrode 81 and the downbeam electrode 83 result in a stronger collimation effect. In this way, the collimation of the plurality of beams in the beam grid (or any other operation which is performed on the plurality of beams in the beam grid) can be controlled, just by controlling the second potential.

The above description has focused on the case where the charged particle-optical element comprises 80 three electrodes (i.e. the upbeam electrode 81, the intermediate electrode 82 and the downbeam electrode 83). However, the presence of three electrodes is not essential for the present invention.

As explained above, the collimation effect achieved by the charged particle-optical element 80 depicted in **FIG. 7** is a result of a force exerted on charged particles in the off-axis beams in the radially inward direction. That is, the charged particles in beams that have a radially outward velocity component experience a radially inward force, causing the radially outward velocity component to decrease (to zero for full collimation). In other words, it is the radially inward force which results in the collimation of the plurality of beams of the beam grid. The radially inward force is experienced by the charged particles in the off-axis beams when passing between the upbeam electrode 81 and the intermediate electrode 82, and when passing between the intermediate electrode 82 and the downbeam electrode 83. Considering this, it will be recognized that providing only: (i) the upbeam electrode 81 and the intermediate electrode 82 of the embodiment depicted in **FIG. 7,** or (ii) the intermediate electrode 82 and the downbeam electrode 83 of the embodiment depicted in **FIG 7,** would result in some collimation effect.

**FIGS. 13 to 16** depict various charge particle-optical element 80 in accordance with embodiments. **FIGS. 13 to 16** depict only beam areas of the electrodes of the charge particle-optical elements 80. **FIG. 13** schematically depicts a charged particle-optical element 80 comprising an upbeam electrode 81 and an intermediate electrode 82. Note that the term "intermediate" is used here as a label, and it is not implied that there is a further electrode downbeam of the intermediate electrode 82. In the arrangement depicted in **FIG. 13** a potential difference is applied between the upbeam electrode 81 and the downbeam electrode 82 by applying a first potential to the upbeam electrode 81 and a second potential to the intermediate electrode 82, where the second potential is less than the first potential. The upbeam electrode 81 and the intermediate electrode 82 may be substantially the same as the upbeam electrode 81 and the intermediate electrode 82 described with reference to **FIG. 7.** Collimation of the plurality of beams of the beam grid may occur between the upbeam electrode 81 and the intermediate electrode 82 of the embodiment depicted in **FIG. 13** in the same way as the collimation of the plurality of beams of the beam grid occurs between the upbeam electrode 81 and the intermediate electrode 82 in the embodiment depicted in **FIG. 7.**

In the arrangement depicted in **FIG. 13,** the intermediate electrode 82 remains substantially flat. This is in spite of the fact that an electrostatic pressure is exerted on the intermediate electrode 82 in the upbeam direction, but no electrostatic pressure is exerted on the intermediate electrode in the downbeam direction. The intermediate electrode 82 may remain substantially flat, e.g. by virtue of having a high stiffness (which may be a result of the intermediate electrode 82 having a higher thickness than the upbeam electrode 81). Alternatively, the intermediate electrode 82 may have a pre-bending in a downbeam direction before applying the first potential and the second potential and by applying the required first potential and the second potential, the intermediate electrode 82 will take the required shape (in this case to be substantially flat).

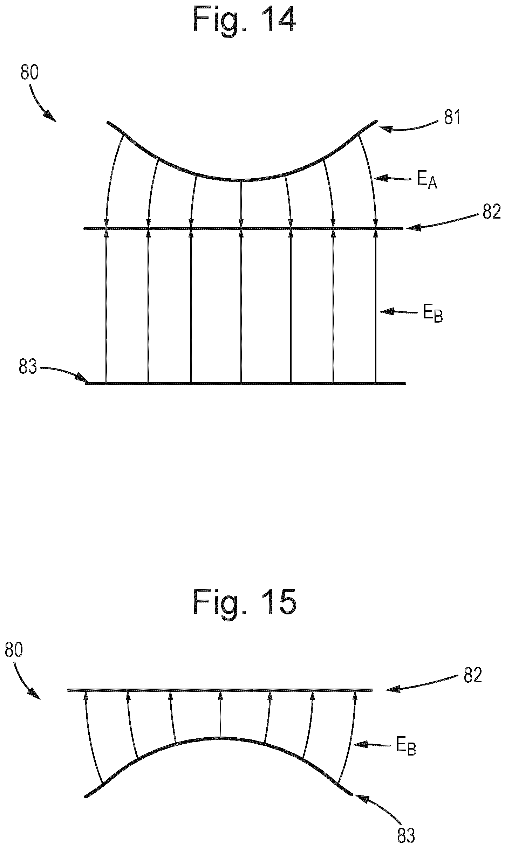

**FIG. 14** depicts a variant of the embodiment depicted in **FIG. 13** in which a downbeam electrode 83 is provided downbeam of the intermediate electrode 82. The downbeam electrode 83 of the embodiment depicted in **FIG. 14** differs from the downbeam electrode 83 of the embodiment depicted in **FIG. 7** in that the downbeam electrode 83 of the embodiment depicted in **FIG. 14** is configured to remain flat in the activated state. To achieve this, the downbeam electrode 83 may, e.g. have a high stiffness (e.g. a higher stiffness than the upbeam electrode 81). In the embodiment of **FIG. 14,** because the downbeam electrode 83 is substantially flat, the field $E_B$ between the intermediate electrode 82 and the downbeam electrode 83 does not have a lateral/radial component. If the charged particle-optical element 80 is to be an Einzel lens configuration, the downbeam electrode 83 may be provided to accelerate the charged particles in the plurality of beams of the beam grid (e.g. after deceleration of the plurality of charged particles in the beams of the beam grid between the upbeam electrode 81 and the intermediate electrode 82). To achieve this, the third potential may be greater than the second potential, and may be the same as the first potential. The charged particle-optical element 80 depicted in **FIG. 14** may be less effective than the charged particle-optical element 80 depicted in, e.g. **FIG. 10.** This is because collimation of the plurality of beams of the beam grid as a result of the radial component of the electric field only occurs between the upbeam electrode 81 and the intermediate electrode 82 (rather than between the upbeam electrode 81 and the intermediate electrode 82 and between the intermediate electrode 82 and the downbeam electrode 83, as in the charged particle-optical element 80 depicted in, e.g. **FIG. 10).**

**FIG. 15** depicts a charged particle-optical element 80 comprising an intermediate electrode 82 and a downbeam electrode 83. Note that the term "intermediate" is used here as a label, and it is not implied that there is a further electrode upbeam of the intermediate electrode 82. A second potential is applied to the intermediate electrode 82 and a third potential is applied to the downbeam electrode 83, where the third potential is greater than the second potential. Collimation of the plurality of beams of the beam grid may occur between the intermediate electrode 82 and the downbeam electrode 83 of the embodiment depicted in **FIG. 15** in the same way as the collimation of the plurality of beams of the beam grid occurs between the intermediate electrode 82 and the downbeam electrode 83 in the embodiment depicted in **FIG. 7.**

In the arrangement depicted in **FIG. 15,** the intermediate electrode 82 remains substantially flat. This is in spite of the fact that an electrostatic pressure is exerted on the intermediate electrode 82 in the downbeam direction, but no electrostatic pressure is exerted on the intermediate electrode 82 in the upbeam direction. The downbeam electrode 82 may remain substantially flat by virtue of having a high stiffness (which may be a result of the intermediate electrode 82 having a higher thickness than the downbeam electrode 83). Alternatively, the intermediate electrode 82 may have a prebending in an upbeam direction before applying the second potential and the third potential and by applying the required second potential and the third potential, the intermediate electrode 82 will take the required shape (in this case to be substantially flat).

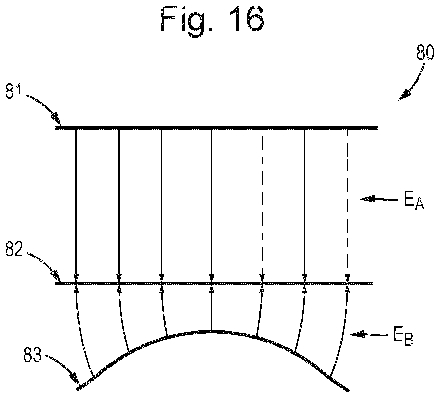

**FIG. 16** depicts a variant of the embodiment depicted in **FIG. 15** in which an upbeam electrode 81 is provided. The upbeam electrode 81 of the embodiment depicted in **FIG. 16** differs from the upbeam electrode of the embodiment depicted in **FIG. 7** in that the upbeam electrode 81 of the embodiment depicted in **FIG. 16** is configured to remain substantially flat when the charged particle-optical element 80 is in the activated state. This may be achieved by the upbeam electrode 81 having a high stiffness (e.g. by having a large thickness). In the embodiment of **FIG. 16,** because the upbeam electrode 81 is substantially flat, the field $E_A$ between the intermediate electrode 82 and the upbeam electrode 81 does not have a lateral/radial component. If the charged particle-optical element 80 is to be an Einzel lens configuration, the upbeam electrode 81 may be provided to decelerate the plurality of beams of the beam grid (e.g. before the plurality of beams of the beam grid are accelerated between the intermediate electrode 82 and the downbeam electrode 83). To achieve this, the first potential may be greater than the second potential, and may be the same as the first potential. The charged particle-optical element 80 depicted in **FIG. 16** may be less effective than the charged particle-optical element 80 depicted in, e.g. **FIG. 10.** This is because collimation of the plurality of beams of the beam grid as a result of the radial component of the electric field only occurs between the intermediate electrode 82 and the downbeam electrode 83 (rather than between the upbeam electrode 81 and the intermediate electrode 82 and between the intermediate electrode 82 and the downbeam electrode 83, as in the charged particle-optical element 80 depicted in, e.g. **FIG. 10).**

The above description has referred to the application of a potential difference between electrodes 81, 82, 83 of the charged particle-optical device 80 in such a way that an electrostatic pressure exerted on one or more of the electrodes 81, 82, 83 causes that electrode 81, 82, 83 to adopt a target curvature. It will be recognised that this technique may be used in the charged particle-optical device 90 depicted in Figure 6.

Embodiments of the present invention are further described in the following numbered clauses:

Clause 1: a charged particle-optical element for a charged particle beam apparatus, wherein the charged particle-optical element is configured to operate on a plurality of beamlets of charged particles, and the charged particle-optical element comprises:

a first electrode, wherein a plurality of first apertures for passage of the plurality of beamlets are defined in a beam area of the first electrode; and a second electrode, wherein a plurality of second apertures for passage of the plurality of beamlets are defined in a beam area of the second electrode,
wherein the first electrode is configured to adopt a target curved profile upon application of a potential difference between the first electrode and the second electrode.

Clause 2: the charged particle-optical element of clause 1, wherein the target curved profile of the first electrode is such that a curvature of the beam area of the first electrode is substantially spherical with a radius that is less than 100 mm.

Clause 3: the charged particle-optical element of clause 1 or 2, wherein the first electrode is upbeam of the second electrode.

Clause 4: the charged particle-optical element of clause 1 or 2, wherein the first electrode is downbeam of the second electrode.

Clause 5: the charged particle-optical element of any of the preceding clauses, wherein the second electrode is configured to be substantially flat upon the application of the potential difference between the first electrode and the second electrode.

Clause 6: the charged particle-optical element of any of the preceding clauses, wherein the curved profile of the first electrode is such that a distance between a radially inner portion of the first electrode and a radially inner portion of the second electrode is less than a distance between a radially outer portion of the first electrode and a radially outer portion of the second electrode.

Clause 7: the charged particle-optical element of any of the preceding clauses, wherein the charged particle-optical element further comprises a third electrode arranged such that the second electrode is interposed between the first electrode and the third electrode, and wherein a plurality of third apertures for passage of the plurality of beamlets are defined in a beam area of the third electrode.

Clause 8: the charged particle-optical element of clause 7, wherein the third electrode is configured to adopt a target curved profile upon application of a potential difference between the third electrode and the second electrode.

Clause 9: the charged particle-optical element of clause 8, wherein the target curved profile of the third electrode is such that a curvature of the beam area of the third electrode is substantially spherical with a radius that is less than 100 mm.

Clause 10: the charged particle-optical element of clause 8 or 9, wherein the first electrode is upbeam of the second electrode and the third electrode is downbeam of the second electrode.

Clause 11: the charged particle-optical element of any of the preceding clauses, wherein the curved profile of the third electrode is such that a distance between a radially inner portion of the third electrode and a radially inner portion of the second electrode is less than a distance between a radially outer portion of the third electrode and a radially outer portion of the second electrode.

Clause 12: the charged particle-optical element of any of the preceding clauses, wherein the charged particle-optical element is a collimator array configured to increase the mutual collimation of the plurality of beamlets.

Clause 13: the charged particle-optical element of any of the preceding clause, wherein the first electrode is supported at a support portion thereof, wherein a radially inner boundary of the support portion is substantially circular.

Clause 14: the charged particle-optical element of clause 13, wherein a diameter of the radially inner boundary of the support portion is greater than 40 mm.

Clause 15: the charged particle-optical element of clause 13 or 14, wherein the charged particle-optical element comprises one or more spacers configured to support the first electrode at the support portion of the first electrode.

Clause 16: the charged particle-optical element of any of the preceding clauses, wherein a thickness of the first electrode is less than 100 $\mu$m.

Clause 17: the charged particle-optical element of clause 16, wherein the thickness of the first electrode is less than 50 $\mu$m.

Clause 18: the charged particle-optical element of any of the preceding clauses, wherein a thickness of the first electrode is greater than 25 $\mu$m.

Clause 19: the charged particle-optical element of any of clauses 13 to 18, wherein a thickness of the beam area of the first electrode is less than a thickness of a peripheral area of the first electrode, wherein the peripheral area of the first electrode is interposed between the beam area of the first electrode and the support portion of the first electrode.

Clause 20: the charged particle-optical element of any of the preceding clauses, wherein the first electrode and/or the third electrode, where present, comprises one or more holes configured to decrease a local stiffness of the first electrode and/or the third electrode, wherein the one or more holes are arranged such that the plurality of beamlets of the beam grid do not pass through the one or more holes.

Clause 21: the charged particle-optical element of any of the preceding clause, wherein the first electrode and/or the third electrode, where present, comprises one or more recessed portions configured to decrease the local stiffness of the first electrode and/or the third electrode.

Clause 22: the charged particle-optical element of any of the preceding clauses, wherein the curved profile adopted by the first electrode is at least in part a result of a pre-deformation of the first electrode and the application of the potential difference between the first electrode and the second electrode, and/or, where the third electrode is present, the curved profile adopted by the third electrode is at least in part a result of a pre-deformation of the third electrode and the application of the potential difference between the third electrode and the second electrode.

Clause 23: the charged particle-optical element of any of the preceding clauses, further comprising one or more actuators configured to apply a force to the first electrode, and wherein the curved profile adopted by the first electrode is at least in part a result of the force applied to the first electrode by the one or more actuators and the application of the potential difference between the first electrode and the second electrode, and/or further comprising one or more actuators configured to apply a force to the third electrode, and wherein the curved profile adopted by the third electrode is at least in part a result of the force applied to the third electrode by the one or more actuators and the application of the potential difference between the third electrode and the second electrode.

Clause 24: the charged particle-optical element of any of the preceding clauses, further comprising one or more actuators configured to apply a force to the second electrode, wherein the force applied to the second electrode is configured to increase a flatness of the second electrode.

Clause 25: the charged particle-optical element of any of clauses 6 to 24, wherein the charged particle-optical element comprises the third electrode, and the third electrode is structurally similar to, or structurally the same as, the first electrode.

Clause 26: the charged particle-optical element of any of the preceding clauses, wherein one or more of the first electrode, the second electrode and the third electrode are formed from a material comprising silicon.

Clause 27: the charged particle-optical element of any of the preceding clauses, wherein one or more of the first electrode, the second electrode and the third electrode are plates.

Clause 28: the charged particle-optical element of any of the preceding clauses, wherein the charged particle-optical element is an electron-optical element, and wherein the plurality of beamlets of charged particles are a plurality of beamlets of electrons.

Clause 29: a system comprising the charged particle-optical element of any of the preceding clauses, a power source and a controller, wherein the controller is configured to control the power source to apply the potential difference between the first electrode and the second electrode.

Clause 30: a system comprising the charged particle-optical element of any of clauses 7 to 28, a power source and a controller, wherein the controller is configured to control the power source to apply the potential difference between the first electrode and the second electrode and to apply the potential difference between the second electrode and the third electrode.

Clause 31: the system of clause 30, wherein the controller is configured to control the power source to apply a first potential to the first electrode, to apply a second potential to the second electrode, and to apply a third potential to the third electrode.

Clause 32: the system of clause 31, wherein the first potential is more positive than the second potential, and the third potential is more positive than the second potential.

Clause 33: the system of clause 31 or 32, wherein the first potential is substantially the same as the third potential.

Clause 34: the system of any of clauses 29 to 33, wherein the curved profile of the first electrode and/or the curved profile of the third electrode is/are controllable by adjusting one or more of the first potential, the second potential and the third potential.

Clause 35: a charged particle beam apparatus comprising the charged particle-optical element of any of clauses 1 to 28 or the system of any of clauses 29 to 34.

Clause 36: the charged particle beam apparatus of clause 35, wherein the charged particle beam apparatus is a multibeam apparatus configured to project a plurality of beamlets of charged particles towards a sample.

Clause 37: the charged particle beam apparatus of any of clauses 35 or 36, wherein the charged particle beam apparatus is a multibeam scanning electron microscope or a multibeam transmission electron microscope.

Clause 38: a method of operating a charged particle beam apparatus for assessing a sample, the method comprising use of the charged particle beam apparatus of any of clauses 35 to 37.

Clause 39: the charged particle beam apparatus of any of clauses 35 or 36, wherein the charged particle beam apparatus is an electron beam lithography apparatus.

Clause 40: a method of operating a charged particle-optical element of a charged particle beam apparatus for directing a plurality of beamlets of charged particles towards a sample, the charged particle-optical element comprising:

a first electrode, wherein a plurality of first apertures for passage of the plurality of beamlets are defined in a beam area of the first electrode; and a second electrode, wherein a plurality of second apertures for passage of the plurality of beamlets are defined in a beam area of the second electrode,

the method comprising applying a potential difference between the first electrode and the second electrode, wherein the application of the potential difference between the first electrode and the second electrode reduces a difference between the curvature of the beam area of the first electrode and a target curvature for the beam area of the first electrode.

Clause 41: the method of clause 40, wherein the target curvature for the beam area of the first electrode is a substantially spherical curvature with a radius that is less than 100 mm.

Clause 42: the method of clause 40 or 41, wherein the application of the potential difference between the first electrode and the second electrode increases the curvature of the beam area of the first electrode.

Clause 43: the method of any of clauses 40 to 42, wherein the charged particle-optical element further comprises a third electrode arranged such that the second electrode is interposed between the first electrode and the third electrode, wherein a plurality of third apertures for passage of the plurality of beamlets are defined in a beam area of the third electrode, and the method further comprises applying a potential difference between the third electrode and the second electrode.

Clause 44: the method of clause 43, wherein the application of the potential difference between the third electrode and the second electrode reduces a difference between the curvature of the beam area of the third electrode and a target curvature for the beam area of the third electrode.

Clause 45: the method of clause 44, wherein the target curvature for the beam area of the third electrode is a spherical curvature with a radius that is less than 100 mm.

Clause 46: the method of any of clauses 43 to 45, wherein the application of the potential difference between the second electrode and the third electrode increases a curvature of the beam area of the third electrode.

Clause 47: the method of any of clauses 40 to 46, further comprising directing the plurality of charged particle beamlets through the plurality of first apertures in the first electrode, directing the plurality of charged particle beamlets through the plurality of second apertures in the second electrode, and directing the plurality of charged particle beamlets through the plurality of third apertures in the third electrode.

Clause 48: the method of clause 47, wherein the directing the plurality of charged particle beamlets through the plurality of first apertures, the plurality of second apertures and the plurality of third apertures increases a mutual collimation of the plurality of charged particle beamlets.

Clause 49: a method of assessing a sample, the method comprising the method of operating a charged particle-optical element of any of clauses 40 to 48.

As used herein, the term "flat" or "substantially flat" may refer to curvature with a radius of greater than 1 m, or greater than 10 m.

As used herein, the use of ordinal numbers (i.e. first, second, third etc.) is to provide distinct labels for different features and components such that they can be referred to easily. The ordinal number assigned to a component or feature is not intended to imply any structural or functional attributes of the component or feature. For instance, where first, second and third plates are provided within an electron-optical device, the order of the plates in the downbeam direction is not necessarily the first plate followed by the second plate followed by the third plate. Further, the existence of a "second feature" does not necessarily imply the presence of a "first feature".

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

## Claims

1. A charged particle-optical element for a charged particle beam apparatus, wherein the charged particle-optical element is configured to operate on a plurality of beamlets of charged particles, and the charged particle-optical element comprises:

   a first electrode, wherein a plurality of first apertures for passage of the plurality of beamlets are defined in a beam area of the first electrode; and
   a second electrode, wherein a plurality of second apertures for passage of the plurality of beamlets are defined in a beam area of the second electrode,
   wherein the first electrode is configured to adopt a target curved profile upon application of a potential difference between the first electrode and the second electrode.

2. The charged particle-optical element of claim 1, wherein the target curved profile of the first electrode is such that a curvature of the beam area of the first electrode is substantially spherical with a radius that is less than 100 mm.

3. The charged particle-optical element of claim 1 or 2, wherein the first electrode is upbeam of the second electrode, or wherein the first electrode is downbeam of the second electrode.

4. The charged particle-optical element of any of the preceding claims, wherein the second electrode is configured to be substantially flat upon the application of the potential difference between the first electrode and the second electrode.

5. The charged particle-optical element of any of the preceding claims, wherein the curved profile of the first electrode is such that a distance between a radially inner portion of the first electrode and a radially inner portion of the second electrode is less than a distance between a radially outer portion of the first electrode and a radially outer portion of the second electrode.

6. The charged particle-optical element of any of the preceding claims, wherein the charged particle-optical element further comprises a third electrode arranged such that the second electrode is interposed between the first electrode and the third electrode, and wherein a plurality of third apertures for passage of the plurality of beamlets are defined in a beam area of the third electrode.

7. The charged particle-optical element of claim 6, wherein the third electrode is configured to adopt a target curved profile upon application of a potential difference between the third electrode and the second electrode.

8. The charged particle-optical element of claim 6 or 7, wherein the first electrode is upbeam of the second electrode and the third electrode is downbeam of the second electrode.

9. The charged particle-optical element of any of the preceding claims, wherein the charged particle-optical element is a collimator array configured to increase the mutual collimation of the plurality of beamlets.

10. The charged particle-optical element of any of the preceding claims, wherein the first electrode is supported at a support portion thereof, wherein a radially inner boundary of the support portion is substantially circular.

11. The charged particle-optical element of any of claims 9 to 10, wherein a thickness of the beam area of the first electrode is less than a thickness of a peripheral area of the first electrode, wherein the peripheral area of the first electrode is interposed between the beam area of the first electrode and the support portion of the first electrode.

12. The charged particle-optical element of any of the preceding claims, wherein the first electrode and/or the third electrode, where present, comprises one or more holes configured to decrease a local stiffness of the first electrode and/or the third electrode, wherein the one or more holes are arranged such that the plurality of beamlets of the beam grid do not pass through the one or more holes, and/or wherein the first electrode and/or the third electrode, where present, comprises one or more recessed portions configured to decrease the local stiffness of the first electrode and/or the third electrode.

13. The charged particle-optical element of any of the preceding claims, wherein the curved profile adopted by the first electrode is at least in part a result of a pre-deformation of the first electrode and the application of the potential difference between the first electrode and the second electrode, and/or, where the third electrode is present, the curved profile adopted by the third electrode is at least in part a result of a pre-deformation of the third electrode and the application of the potential difference between the third electrode and the second electrode.

14. The charged particle-optical element of any of the preceding claims, further comprising one or more actuators configured to apply a force to the first electrode, and wherein the curved profile adopted by the first electrode is at least in part a result of the force applied to the first electrode by the one or more actuators and the application of the potential difference between the first electrode and the second electrode, and/or further comprising one or more actuators configured to apply a force to the third electrode, and wherein the curved profile adopted by the third electrode is at least in part a result of the force applied to the third electrode by the one or more actuators and the application of the potential difference between the third electrode and the second electrode, and/or further comprising one or more actuators configured to apply a force to the second electrode, wherein the force applied to the second electrode is configured to increase a flatness of the second electrode.

15. A system comprising the charged particle-optical element of any of the preceding claims, a power source and a controller, wherein the controller is configured to control the power source to apply the potential difference between the first electrode and the second electrode.

# Fig. 1

# Fig. 2

# Fig. 3

# Fig. 4

# Fig. 5

# Fig. 6

90

91c

91

91c

92c

92c

92

93c

93c

94c

93

94c

93

94

# Fig. 7

80

81u

81

81d

81B

$E_A$

82u

82

82d

$E_B$

83u

83

83B

83d

## Fig. 8

81B

82B

83B

## Fig. 9

85

85

R

81

81B

# Fig. 10

# Fig. 11

# Fig. 12

B

86    87    88    89    86

81

$E_A$

# Fig. 13

80    81

$E_A$

82

## Fig. 14

## Fig. 15

# Fig. 16

**EUROPEAN SEARCH REPORT**

Application Number

EP 24 20 8689

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 503 587 A2 (MAPPER LITHOGRAPHY IP BV [NL]) 26 September 2012 (2012-09-26) * paragraph [0060]; figures 5,10B * ----- | 1-3,15 | INV. H01J37/147 H01J37/28 |
| X | JP 2013 165234 A (CANON KK) 22 August 2013 (2013-08-22) * figures * ----- | 1-3,6-9, 15 | |
| X | US 2024/105416 A1 (WIELAND MARCO JAN-JACO [NL]) 28 March 2024 (2024-03-28) * paragraphs [0068], [0077], [0104], [0116], [0117], [0127]; figures 10-12 * ----- | 1-10,13, 15 | |
| | | | **TECHNICAL FIELDS SEARCHED (IPC)** H01J |

The present search report has been drawn up for all claims

| Place of search | Date of completion of the search | Examiner |
|---|---|---|
| The Hague | 5 May 2025 | Schmidt-Kärst, S |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

............................................................................................
& : member of the same patent family, corresponding
   document

EPO FORM 1503 03.82 (P04C01)

Europäisches
Patentamt

European
Patent Office

Office européen
des brevets

**Application Number**

EP 24 20 8689

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-10, 13, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

## LACK OF UNITY OF INVENTION
### SHEET B

The Search Division considers that the present European patent application does not comply with the requirements of unity of invention and relates to several inventions or groups of inventions, namely:

1. claims: 1-10, 13, 15

   A charged particle-optical element comprising:
   - a first electrode, wherein a plurality of first apertures for passage of a plurality of beamlets are defined in a beam area of the first electrode; and
   - a second electrode, wherein a plurality of second apertures for passage of the plurality of beamlets are defined in a beam area of the second electrode,
   - the first electrode being configured to adopt a target curved profile upon application of a potential difference between the first electrode and the second electrode, wherein the target curved profile of the first electrode is such that a curvature of the beam area of the first electrode is substantially spherical.
   ---

2. claims: 11, 12

   A charged particle-optical element comprising:
   - a first electrode, wherein a plurality of first apertures for passage of a plurality of beamlets are defined in a beam area of the first electrode; and
   - a second electrode, wherein a plurality of second apertures for passage of the plurality of beamlets are defined in a beam area of the second electrode,
   - the first electrode being configured to adopt a target curved profile upon application of a potential difference between the first electrode and the second electrode, wherein a thickness of the beam area of the first electrode is less than a thickness of a peripheral area of the first electrode, or
   wherein the first electrode comprises one or more holes, wherein the one or more holes are arranged such that the plurality of beamlets of the beam grid do not pass through the one or more holes, or
   wherein the first electrode comprises one or more recessed portions.
   ---

3. claim: 14

   A charged particle-optical element comprising:
   - a first electrode, wherein a plurality of first apertures for passage of a plurality of beamlets are defined in a beam area of the first electrode; and
   - a second electrode, wherein a plurality of second apertures for passage of the plurality of beamlets are defined in a beam area of the second electrode,
   - the first electrode being configured to adopt a target curved profile upon application of a potential difference

Europäisches
Patentamt

European
Patent Office

Office européen
des brevets

## LACK OF UNITY OF INVENTION
## SHEET B

Application Number

EP 24 20 8689

The Search Division considers that the present European patent application does not comply with the requirements of unity of invention and relates to several inventions or groups of inventions, namely:

between the first electrode and the second electrode, wherein the charged particle-optical element further comprises one or more actuators configured to apply a force to any of the electrodes, and wherein the curved profile adopted by said electrode is at least in part a result of the force applied to the said electrode by the one or more actuators and the application of the potential difference between the electrodes.

---

## ANNEX TO THE EUROPEAN SEARCH REPORT
## ON EUROPEAN PATENT APPLICATION NO.

EP 24 20 8689

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2025

| Patent document cited in search report | | Publication date | Patent family member(s) | | Publication date |
|---|---|---|---|---|---|
| EP 2503587 | A2 | 26-09-2012 | CN | 1759465 A | 12-04-2006 |
| | | | EP | 1602121 A2 | 07-12-2005 |
| | | | EP | 2503587 A2 | 26-09-2012 |
| | | | JP | 4484868 B2 | 16-06-2010 |
| | | | JP | 2006520078 A | 31-08-2006 |
| | | | KR | 20050102688 A | 26-10-2005 |
| | | | US | 7348567 B1 | 25-03-2008 |
| | | | US | 2004232349 A1 | 25-11-2004 |
| | | | US | 2007018112 A1 | 25-01-2007 |
| | | | US | 2007029499 A1 | 08-02-2007 |
| | | | US | 2007029509 A1 | 08-02-2007 |
| | | | WO | 2004081910 A2 | 23-09-2004 |
| JP 2013165234 | A | 22-08-2013 | NONE | | |
| US 2024105416 | A1 | 28-03-2024 | CN | 117730392 A | 19-03-2024 |
| | | | EP | 4102536 A1 | 14-12-2022 |
| | | | EP | 4352774 A1 | 17-04-2024 |
| | | | IL | 309124 A | 01-02-2024 |
| | | | JP | 2024523820 A | 02-07-2024 |
| | | | KR | 20240017084 A | 06-02-2024 |
| | | | TW | 202303658 A | 16-01-2023 |
| | | | US | 2024105416 A1 | 28-03-2024 |
| | | | WO | 2022258279 A1 | 15-12-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2425444 A
- EP 20184161 A
- EP 20158804
- EP 20158732